# EUROPEAN PATENT APPLICATION

(11) **EP 4 814 960 A1**
(43) Date of publication of application: **30.09.2026**
(21) Application number: 26168685.1
(22) Date of filing: 27.03.2026
(51) Int. Cl.: G11C 7/04, G11C 7/06, G11C 7/14, G11C 11/16, G11C 11/22, G11C 13/00

(54) **MIDPOINT SENSING REFERENCE GENERATION FOR STT-MRAM**

(30) Priority: 28.03.2025 US 202563779538 P; 11.03.2026 US 202619563057
(71) Applicant: Everspin Technologies, Inc., Chandler, Arizona 85226 (US)
(72) Inventor: ALAM, Syed M., CHANDLER, 85226 (US); SADD, Michael A., CHANDLER, 85226 (US)
(74) Representative: Eisenführ Speiser

(57) **Abstract**

The present disclosure is drawn to a magnetoresistive memory (MRAM) comprising a magnetoresistive memory array comprising a plurality of magnetoresistive devices arranged in rows and columns, wherein the columns include a reference column and a regular column, the regular column includes a regular bit line and a first subset of magnetoresistive devices coupled to the regular bit line and select devices within the regular column, and the reference column includes a reference bit line, a dummy reference bit line, and a second subset of magnetoresistive devices coupled to the dummy reference bit line. The reference bit line is coupled to selective devices within the reference column. The MRAM also includes a column selection circuitry configured to select the regular bit line or the reference bit line, a sense amplifier coupled to the column selection circuitry, and a trim circuit midpoint generator including a tracking circuit and a programmable resistance.

## Description

### CROSS-REFERENCE TO RELATED APPLICATION

This application claims benefit to U.S. Application No. 19/563,057, filed March 11, 2026, which claims benefit to U.S. Provisional Patent Application No. 63/779,538 filed March 28, 2025, the entire contents of which are incorporated herein by reference.

### TECHNICAL FIELD

Embodiments of the present disclosure relate to magnetoresistive devices. More specifically, embodiments of the present disclosure relate to architectures, integrated circuit layouts, circuits and methods for midpoint sensing reference generation circuitry and method used to sense a data state of a resistive-based memory cell of, for example, a memory cell array including, for example, a spin transfer torque magnetoresistive memory cell and memory cell array.

### INTRODUCTION

A memory system may include a memory device for storing data and a host (or controller) for controlling operations of the memory device. In general, memory devices may be classified into volatile memory (such as, e.g., dynamic random-access memory (DRAM), static random-access memory (SRAM), etc.) and non-volatile memory (such as, e.g., electrically erasable programmable read-only memory (EEPROM), ferroelectric random-access memory (FRAM), phase-change memory (PRAM), magnetoresistive memory (MRAM), resistive random-access memory (RRAM/ReRAM), flash memory, etc.).

A magnetoresistive stack or a magnetic tunnel junction (MTJ) used in MRAM includes at least one non-magnetic layer (for example, at least one dielectric layer or a non-magnetic yet electrically conductive layer) disposed between a "fixed" magnetic region and a "free" magnetic region, each including one or more layers of ferromagnetic materials. Information is stored in the magnetoresistive memory stack by switching, programming, and/or controlling the direction of magnetization vectors in the magnetic layer(s) of the free magnetic region. The direction of the magnetization vectors of the free magnetic region may be switched and/or programmed (for example, through spin orbit torque (SOT) and/or spin transfer torque (STT)) by application of a write signal (e.g., one or more current pulses) adjacent to, or through, the magnetoresistive memory stack.

In particular, an STT-MRAM device stores information by controlling the resistance across an **MTJ** such that a read current through the MTJ results in a voltage drop having a magnitude that is based on the state of the magnetoresistive stack. The resistance in each **MTJ** can be varied based on the relative magnetic states of the magnetoresistive layers within the magnetoresistive stack. In such memory devices, as alluded to above, there is typically a portion of the magnetoresistive stack that has a fixed magnetic state and another portion that has a free magnetic state that is controlled to be either one of two possible states relative to the portion having the fixed magnetic state. Because the resistance through the MTJ changes based on the orientation of the free portion relative to the fixed portion, information can be stored by setting the orientation of the free portion. The information is later retrieved by sensing the orientation of the free portion.

### BRIEF DESCRIPTION OF THE DRAWINGS

In the course of the detailed description that follows, reference will be made to the appended drawings. The drawings show different aspects of the present disclosure and, where appropriate, reference numerals illustrating like structures, components, materials, and/or elements in different figures are la-beled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present disclosure.
FIG. 1 depicts an exemplary schematic diagram of a midpoint generator used in a toggle MRAM device.
FIG. 2 depicts an exemplary graph illustrating a resistance distribution for a toggle MRAM device.
FIG. 3 depicts an exemplary diagram illustrating an array structure of a toggle MRAM device.
FIG. 4 illustrates an exemplary schematic diagram illustrating a local source line array architecture of an STT-MRAM device.
FIG. 5 illustrates another exemplary schematic diagram illustrating a local source line array architecture of an STT-MRAM device.
FIG. 6 depicts an exemplary schematic diagram illustrating a local source line array architecture of an STT-MRAM device configured for midpoint sensing, according to an aspect of the present disclosure.
FIG. 7 depicts another exemplary schematic diagram illustrating a local source line array architecture of an STT-MRAM device configured for midpoint sensing, according to an aspect of the present disclosure.
FIG. 8 depicts an exemplary schematic diagram illustrating a sense amplifier configuration of an STT-MRAM device configured for midpoint sensing, according to an aspect of the present disclosure.
FIG. 9 depicts another exemplary schematic diagram illustrating a sense amplifier configuration of an STT-MRAM device configured for midpoint sensing, according to an aspect of the present disclosure.
FIG. 10 depicts an exemplary schematic block diagram illustrating a shared tracking circuit configuration of an STT-MRAM device configured for midpoint sensing, according to an aspect of the present disclosure.
FIG. 11 depicts an exemplary schematic block diagram illustrating a shared programmable resistance configuration of an STT-MRAM device configured for midpoint sensing, according to an aspect of the present disclosure.
FIG. 12 depicts an exemplary schematic block diagram illustrating a shared reference bit line configuration of an STT-MRAM device configured for midpoint sensing, according to an aspect of the present disclosure.
FIG. 13 depicts an exemplary schematic block diagram illustrating a shared trim circuit midpoint generator configuration of an STT-MRAM device configured for midpoint sensing, according to an aspect of the present disclosure.
FIG. 14 depicts an exemplary schematic block diagram illustrating a shared tracking circuit and reference bit line configuration of an STT-MRAM device configured for midpoint sensing, according to an aspect of the present disclosure.
FIG. 15 depicts an exemplary schematic block diagram illustrating a shared programmable resistance and reference bit line configuration of an STT-MRAM device configured for midpoint sensing, according to an aspect of the present disclosure.
FIG. 16 depicts an exemplary graph illustrating a shift in resistance distribution of low-state **MTJs** and high state **MTJs** based on temperature, according to an aspect of the present disclosure.
FIG. 17 depicts an exemplary diagram illustrating a memory architecture of an STT-MRAM device, according to an aspect of the present disclosure.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

It should be noted that the description set forth herein is merely illustrative in nature and is not intended to limit the embodiments of the subject matter, or the application and uses of such embodiments. Any implementation described herein as exemplary is not to be construed as preferred or advantageous over other implementations. Rather, the term "exemplary" is used in the sense of example or "illustrative," rather than "ideal." The terms "comprise," "include," "have," "with," and any variations thereof are used synonymously to denote or describe a non-exclusive inclusion. As such, a device or a method that uses such terms does not include only those elements or steps, but may include other elements and steps not expressly listed or inherent to such device and method. Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In one aspect, the present disclosure is directed to circuitry, architectures, techniques and implementations (e.g., layouts) for midpoint sensing reference generation in STT-MRAM devices. Though the description below makes reference to MRAM devices, the inventions may be implemented in other memory devices including, but not limited to, EEPROM, FRAM, PRAM, RRAM/ReRAM and/or flash memory. For the sake of brevity, the circuitry, architectures and techniques for midpoint sensing reference generation described and/or illustrated herein in the context of STT-MRAM may not be specifically and/or expressly repeated in connection with, for example, EEPROM, FRAM, PRAM, RRAM/ReRAM and/or flash memory. This notwithstanding, the circuitry, architectures and techniques for midpoint sensing reference generation may be employed in EEPROM, FRAM, PRAM, RRAM/ReRAM and flash memory array in largely the same manner as described and/or illustrated herein in connection with STT-MRAM.

For the sake of brevity, conventional techniques related to reading and writing memory, and other functional aspects of certain systems and subsystems (and the individual operating components thereof) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in or otherwise contemplated with respect to an embodiment of described the subject matter.

Writing to magnetic memory cells can be accomplished by sending a spin-polarized write current through the memory cell where the angular momentum carried by the spin-polarized current can change the magnetic state of the free portion of the magnetic tunnel junction. One of ordinary skill in the art understands that such a current can either be directly driven through the memory cell or can be the result of applying one or more voltages, where the applied voltages result in the desired current. Depending on the direction of the current through the memory cell, the resulting magnetization of the free portion will either be parallel or antiparallel to the fixed portion. If the parallel orientation represents a logic "0", the antiparallel orientation represents a logic "1", or vice versa. Thus, the direction of write current flow through the memory cell determines whether the memory cell is written to a first state or a second state. In such memories, the magnitude of the write current is typically greater than the magnitude of a read current used to sense the information stored in the memory cells.

Each memory cell typically includes a magnetic tunnel junction coupled in series with a corresponding selection transistor that allows each memory cell to be individually selected for access. In some architectures, each memory cell is coupled between two common lines, which are often referred to as a bit line and a source line. A memory array typically includes many bit lines and source lines that allow selective access to subsets of the memory cells within the array. Word lines are coupled to the gates of the selection transistors, thereby controlling current flow through the series circuit of each memory cell based on the voltages applied to the ends of the magnetic memory cell by, for example, the bit lines and source lines.

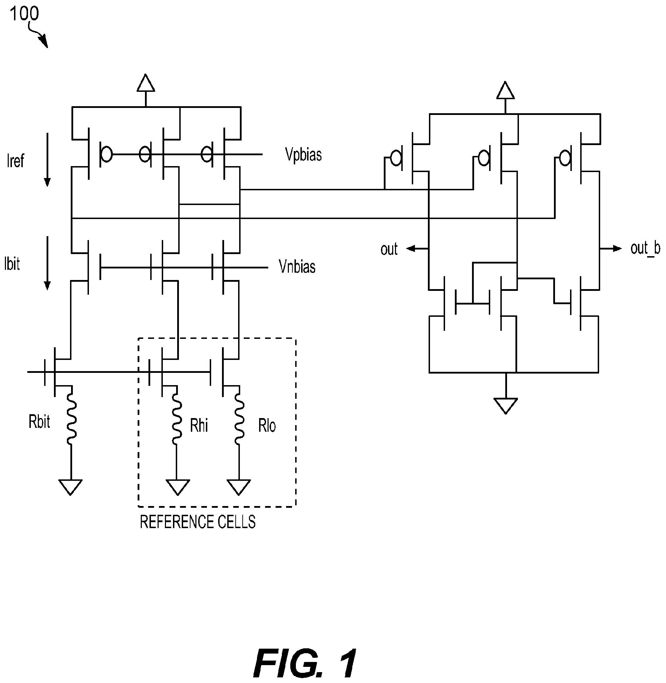

With reference now to FIG. 1, there is depicted an exemplary schematic diagram of a midpoint generator used in a toggle MRAM device. Schematic diagram 100 may illustrate a midpoint sensing with a toggle MRAM uses a parallel connection of high-state and low-state MTJs (e.g., the components designated as Rhi and Rlo in FIG. 1) in a sense amplifier. A current may be measured for the high-state MTJ and the low-state MTJ, and the sum of the currents for the high-state MTJ and the low-state MTJ may be divided by two to determine a midpoint sensing reference.

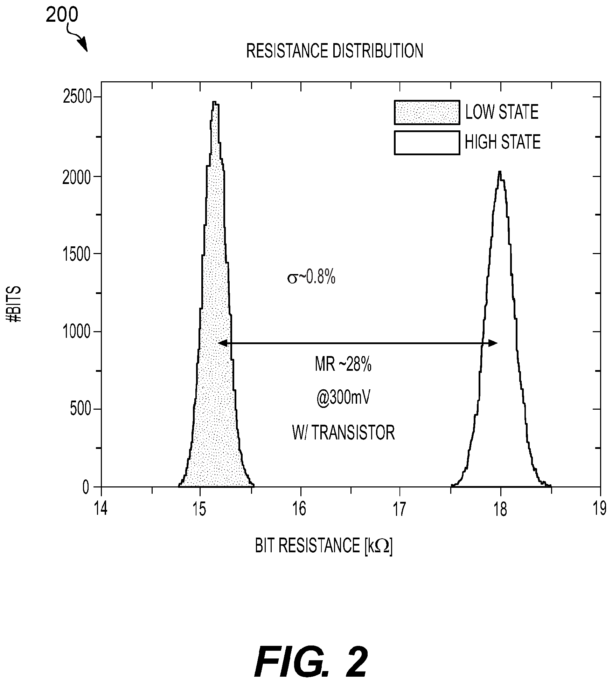

FIG. 2 depicts an exemplary graph illustrating a resistance distribution for a toggle MRAM device. In particular, graph 200 may illustrate the graph plot resistances of the low-state and high-state MTJs (or bits) against a corresponding number of MTJs. Midpoint sensing generally uses a reference, which can be identified in the graph. For instance, the reference may be at the midpoint between the distribution of low-state MTJs and the distribution of high-state MTJs. Magnetoresistance Ratio (MR) may refer to a percentage increase in resistance from a low resistance state to a high resistance state. The reference in between the distributions may be obtained using the circuitry (e.g., midpoint generator) illustrated in FIG. 1.

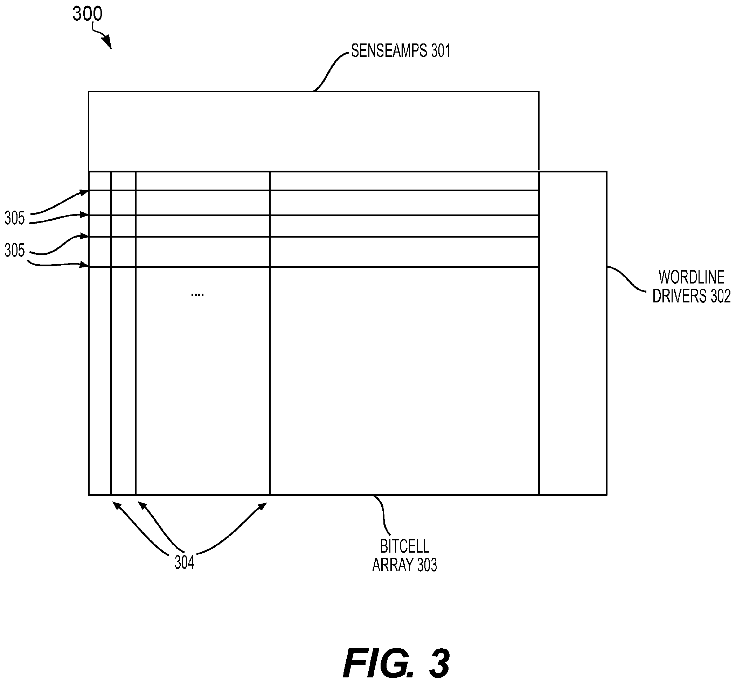

FIG. 3 depicts an exemplary diagram illustrating an array structure of a toggle MRAM device. An array structure 300 may include a bit cell array 303 including bit lines 304 and word lines 305. The sense amplifiers 301 are connected to the plurality of bit lines 304 to provide appropriate voltages to certain bit lines 304 used to perform an operation (e.g., write, read, etc.). Word line drivers 302 generate appropriate word line voltages for word lines 305, in order to select/activate one or more word lines 305 to access MTJ(s) along the selected word line(s) 305. In general, the bit cell array 303 includes a plurality of columns (e.g., one or more sets of 32 or 64 columns), with each column including a plurality of MTJs each coupled to a corresponding select transistor and a bit line 304. The bit cell array 303 also includes a plurality of rows (e.g., one or more sets of 256 rows), each including a corresponding word line 305. An additional reference row for midpoint sensing may be added for every predetermined number of regular rows (e.g., one reference row for every 256 regular rows), such that each reference row is not positioned too far away from the bit cells. Likewise, an additional reference bit line may be added for every predetermined number of regular bit lines 304 (e.g., one reference bit line for every 32 or 64 regular bit lines 304), such that each reference bit line is positioned not too far away from the bit cells. The arrangement of the reference rows and the reference bit lines illustrated in FIG. 3 may be applicable to a toggle MRAM device without any significant degradation in performance because, once the reference is set to be high and low, those states are maintained unless there is an interference from an external magnetic field. Such arrangement may not be feasible in, for example, STT-MRAM devices due to various performance reasons, which will be explained in greater detail below.

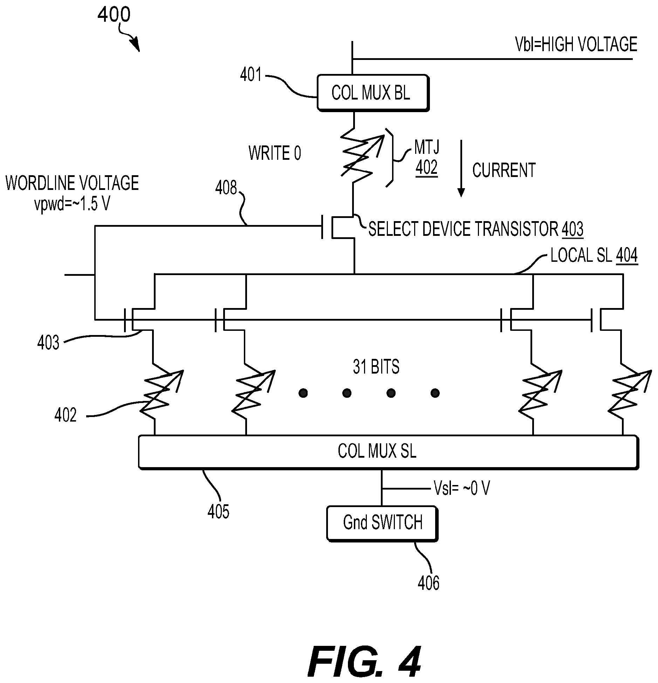

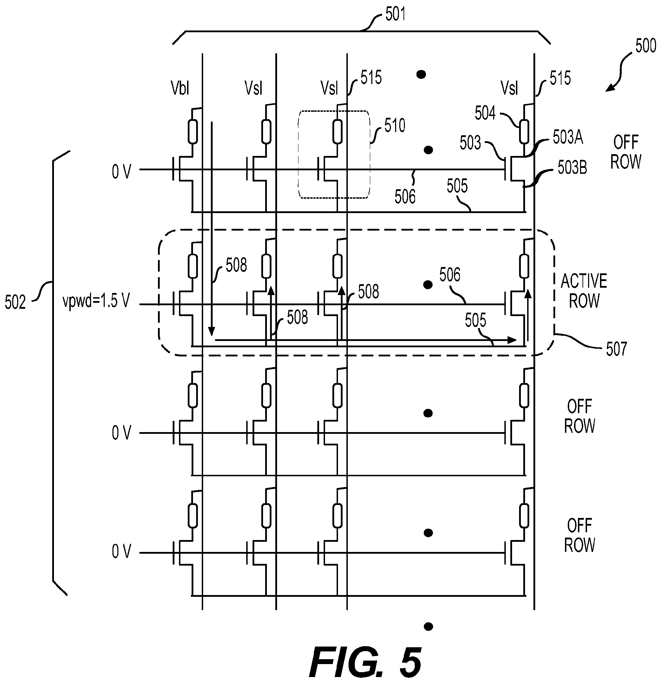

FIG. 4 illustrates an exemplary schematic diagram illustrating a local source line array architecture of an STT-MRAM device. The local source line array architecture 400 of the STT-MRAM device may include a column multiplexer, comprising a bit line multiplexer 401 and a source line multiplexer 405. The bit line multiplexer 401 may be configured to receive a bit line voltage (Vbl) that is generally high. The source line multiplexer 405 may be configured to receive a source line voltage (Vsl) of approximately 0 volts or a ground voltage, which may be provided by a ground (Gnd) switch 406. Voltage is applied to the word line 408 that corresponds to the row including the target MTJ 402. Each magnetic bit cell may include an MTJ 402 and a select device transistor 403 coupled thereto. A local source line 404 may be shared across the row of bit cells (e.g., 32-bitcells), the select device transistor 403 of each bit cell situated on the same row being coupled to the shared local source line 404. The current path for a Write 0 or low state (e.g., down write direction) operation is shown in FIG. 4, which illustrates that the current travels from the bit line multiplexer 401 toward a MTJ 402 selected using the column multiplexer. FIG. 4 illustrates a local source line architecture using a single word line 408. An array of magnetic bit cells may include a plurality of word lines, an example of which is illustrated in FIG. 5.

FIG. 5 illustrates another exemplary schematic diagram illustrating a local source line array architecture of an STT-MRAM device. As shown in FIG. 5, the array structure 500 of an STT-MRAM device may include a plurality of columns 501 and a plurality of rows 502, with each column including a plurality of magnetic bit cells 510. Each magnetic bit cell 510 may include a select transistor 503 and an MTJ 504. Each MTJ 504 may be coupled between a bit line 515 and a first electrode 503A (e.g., a source) of a select transistor, e.g., select transistor 503, while a second electrode 503B (e.g., a drain) of each select transistor 503 may be coupled to a local source line 505 that runs parallel across the row in which the MTJ is positioned. The local source line 505 may thus be shared across all or a certain number (e.g., 32-bitcells) MTJs positioned in that row. A control electrode (e.g., a gate) of each select transistor 503 may be coupled to a word line driver configured to apply voltage to a selected word line or row. Each row may contain a single word line 506 that connects to the control electrodes (e.g., gates) of all select transistors 503 positioned across that row.

The local source line may be a lower level metal layer, and the local source line may be shared among a group of select transistors (e.g., 32 select transistors) situated on the same row. During a read operation, current travels down the bit line 515 to the active row 507 (e.g., the row selected by the word line driver and to which word line voltage is applied), travels through the corresponding local source line 505, and travels back up through neighboring bit cells 510 via the respective bit lines 515, as indicated by the arrows 508 in FIG. 5. In other words, the read is performed in a downward direction (as presented on the page of the drawing) on a bit line 515, and the local source line 505 provides for a return path up the other bit lines 515. The bit lines 515 may be on a high level metal layer (e.g., Metal 4) with low resistance.

Because the return path includes MTJ devices, if a reference column and a corresponding reference row are added to the array according to FIG. 3 array structure of a toggle MRAM device, and the reference column does not have the same MTJ devices as the other columns, a systematic offset may be introduced. Further, the states of MTJs in the return path may cause a mismatch with the reference column during midpoint sensing. To reduce a mismatch, the reference MTJs for midpoint sensing should be placed near the MTJ that is being read. Furthermore, the reference high and low-state MTJs may lose state due to data retention and a read voltage disturbance.

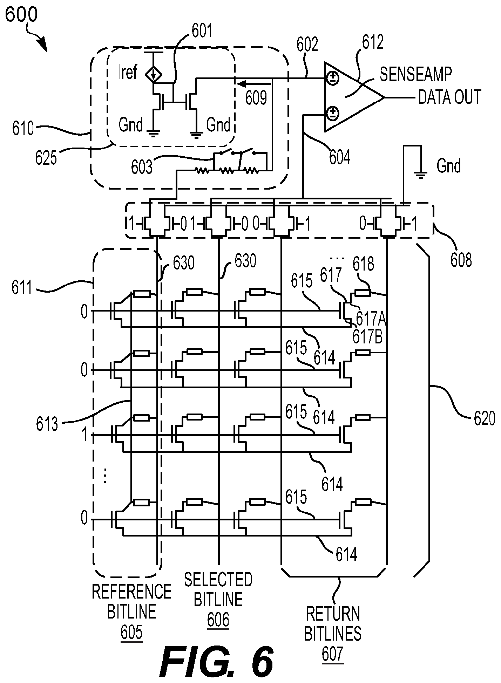

Although a poly resistor may be used for a reference, a poly resistor may be too large to fit in a bit cell array, such as the array shown in FIG. 5. Further, placing the poly resistor outside the bit cell array may not track the word line position for bit line resistance and regular bit line leakage. Additionally, poly resistors may not have voltage and current characteristics identical to those of a regular MTJ. For example, a poly resistor may not track the resistance and MR temperature coefficient of a regular MTJ. Furthermore, a poly resistor may not provide any way to cancel return path MTJ resistance in a local source line array. An exemplary embodiment illustrated in FIG. 6 may minimize or alleviate one or more of the above problems associated with adding a reference region and/or using poly resistors for midpoint reference generation in STT-MRAM devices.

FIG. 6 depicts an exemplary schematic diagram illustrating a local source line array architecture of an STT-MRAM device configured for midpoint sensing, according to an aspect of the present disclosure. The STT-MRAM device 600 may include an STT-MRAM bit cell array 620 (e.g., the bit lines 630 of the array 620) may be coupled to column selection circuitry 608, which may in turn be coupled to a sense amplifier 612. Specifically, a plurality of bit lines 630 in the array 620, including the selected bit line 606 and return bit lines 607, may be electrically coupled to an input 604 of the sense amplifier 612 through the column selection circuitry 608. Further, a reference bit line 605 in the array 620 may be connected to an input 602 of the sense amplifier 612 through the column selection circuitry 608 and a trim circuit midpoint generator 610. The bit cell array 620 may include a plurality of columns, with each column including a plurality of MTJs 618 and select transistors 617 coupled thereto. Notably, the plurality of columns includes a reference column 611 configured for midpoint reference generation, as well as one or more regular columns configured for data storage using MTJs 618. The bit cell array 620 may also include a plurality of rows, with each row including a local source line 614 and the plurality of MTJs 618 connected to the local source line 614 via the respective select transistors 617. Each MTJ 618 may be coupled between the bit line 630 and a first electrode 617A (e.g., a source) of the select transistor (e.g., select transistor 617) while a second electrode 617B (e.g., a drain) of each select transistor 617 may be coupled to the local source line 614 that runs parallel across the row in which the MTJ 618 is positioned. Each row may contain a single word line 615 that connects to the control electrodes (e.g., gates) of all select transistors 617 positioned across that row.

The local source lines 614 may be extended into the reference column 611 and may be electrically connected to the respective second electrodes (e.g., 617B) of the select transistors 617. For example, for every predetermined number of columns (e.g., 32 columns), a reference column 611, including a reference bit line 605 and MTJs 618 connected to the reference bit line 605, may be added as an additional column (e.g., a 33^{rd} column). An advantage of placing a reference bit cell on a same local source line as the other MTJ devices positioned on the same row is that the return path has the same MTJ devices, thus improving uniformity. Additionally, the return path MTJ resistance is present in both reference and regular bit lines during sensing.

Furthermore, the reference column 611 may include an element 613 connected across the MTJs 618 in the reference column 611. According to an exemplary embodiment, the element 613 may be a bridge element (e.g., M3 bridge). In other words, the bridge element 613 may be formed at the 3^{rd} metal layer of the STT-MRAM device. However, any metal layer may be used for the bridge element 613. In some embodiments, any conductive layer may be used for the bridge element 613.

With the bridge element 613 connected across the MTJs 618, all of the MTJs 618 in the reference column 611 are shorted, and the effective resistance of each MTJ 618 becomes small as it is divided by the number of MTJs (e.g., 512) in the reference column 611. Thus, the STT-MRAM device 600 may use the MTJs 618 in the reference column 611 without having any significant impact from the resistance of the MTJs. The MTJs 618 in the reference column 611 does not need to set or reset to high or low states. Furthermore, the shared local source line 614 in the reference column 611 enables the same return path for the reference column 611. According to another exemplary embodiment, the reference column 611 may include a plurality of shorted MTJ devices, in lieu of using a bridge element. According to yet another exemplary embodiment, the reference column 611 may not include any MTJs and there may be a short connecting the reference bit line 605 directly to select transistors 617 in the reference bit line 605. According to yet another exemplary embodiment, the array 620 may include a plurality of reference bit lines 605 with the bridge elements 613, to reduce the return path MTJ resistance even further.

The STT-MRAM device 600 may also include, as part of the trim circuit midpoint generator 610, a temperature-dependent tracking circuit 625 (also referred to herein as a tracking circuit 625) configured for adjusting a temperature coefficient of the current on the reference bit line 605. For example, the column selection circuitry 608 connected to the reference bit line 605 may in turn be connected to a circuit element 603 (e.g., a programmable resistor or resistance) within the trim circuit midpoint generator 610. According to an exemplary embodiment, the circuit element 603 may include one or more poly resistors (e.g., a chain of poly resistors with trim capabilities in multiple ways, by shorting to a transfer gate or any other means). The circuit element 603 may include a fixed resistance, a trimmable resistance, or a combination of a fixed resistance and one or more trimmable resistances depending on the configuration and the application of use. Although the poly resistor is outside the bit cell array 620, array word line position impact and bit line leakage may be matched based on the use of the reference column 611. Poly resistors may have different characteristics than an MRAM MTJ. For instance, to obtain a temperature coefficient that is similar to that of an MTJ, a current trim circuitry may be used that has a temperature dependent magnitude of the current that it takes out from the reference bit line 605. By controlling the current being taken out (e.g., current 609), the amount of resistance the sense amplifier 612 sees on the reference bit line 605 may be controlled. While poly resistors may have characteristics that are different from those of an MTJ, by controlling the reference current, Iref (e.g., 601), the characteristics may become more comparable (or even almost identical) to those of an MTJ. The reference current, Iref, may have a temperature coefficient to match the resistance of the parallel high and low-state MTJs across temperature. A poly resistor resistance value may be determined by using any one of multiple methods, such as an average of low state MTJ and high state MTJ resistances or parallel resistance configuration of low and high state MTJ resistances with any offset resistance. A poly resistor may be implemented with a series of small resistors with a small resolution (e.g., 250 or 500 Ohm) covering a wide range (e.g., 2k Ohm) around a center value (e.g., 4k Ohm).

According to another exemplary embodiment, the trim circuit midpoint generator 610 may use any type of resistor. For example, an n-well resistor may be used. In some embodiments, the resistor trim may be implemented in any one of several ways. For example, the resistor trim may be implemented using a transfer gate, and/or a PMOS switch or NMOS switch. In some embodiments, rather than using an NMOS mirror in the tracking circuit 625, a PMOS mirror may be used to inject current. In some embodiments, the tracking circuit 625 may not contain any current mirror but may include any other tracking circuit to perform the tracking function by providing a temperature dependent voltage. In other embodiments, the tracking circuit 625 may include a current mirror, as shown in FIG. 6. The tracking circuit 625 included in the trim circuit midpoint generator 610 may be configured to control a magnitude of the current Iref or a temperature coefficient. In some embodiments, a combination of one or more poly resistors and one or more n-well resistors may be used to adjust a temperature coefficient without adjusting a current. In other embodiments, trimmable resistors with different temperature coefficients may be configured/programed to achieve a desired temperature coefficient. Further, any two resistive materials with different temperature coefficients may be used together in order to achieve a desired temperature coefficient. In some embodiments, the trimmable resistors may be any programmable voltage and/or current device configured to mimic the desired resistance of the STT-MRAM.

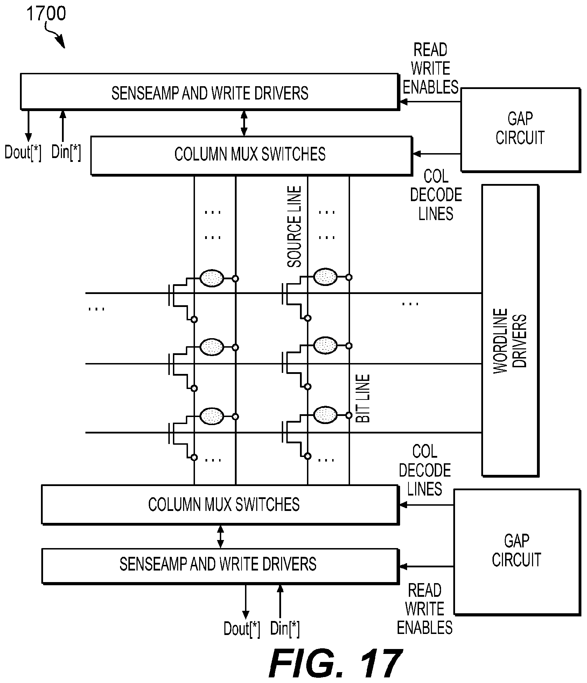

According to another exemplary embodiment, a switch capacitor may be used in place of the poly resistor. The switch capacitor circuit may control a frequency. For example, a voltage-controlled oscillator may be used to track temperature in several ways. While FIG. 6 describes an exemplary embodiment in a local source line array architecture, the aforementioned tracking circuit 625, trim circuit midpoint generator 610, reference column 611, etc., may be used with a standard source line array architecture as in FIG. 17 or any other array architecture.

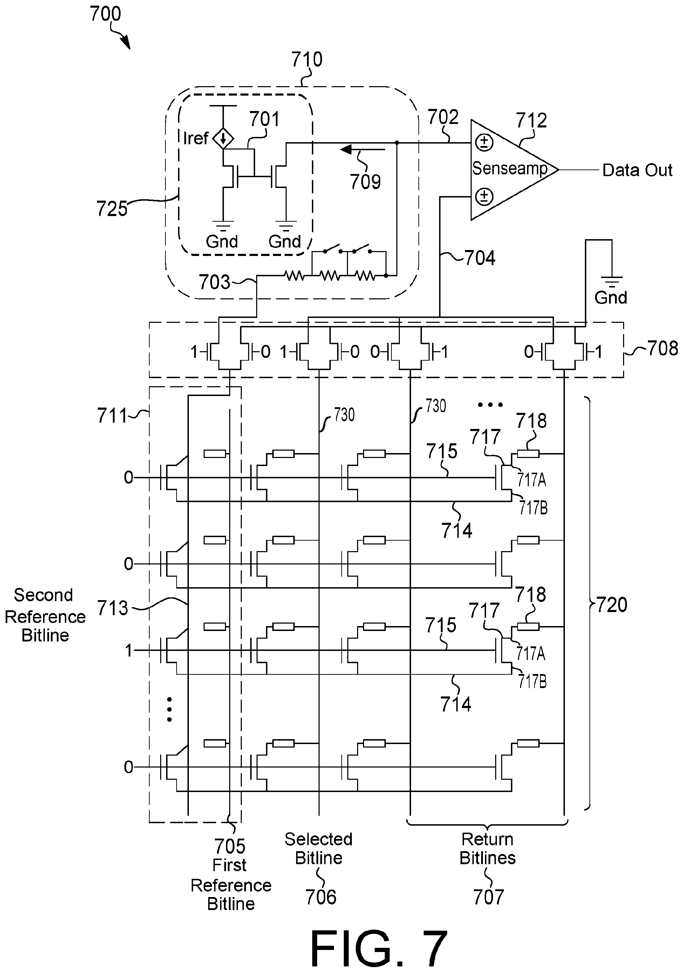

FIG. 7 depicts another exemplary schematic diagram illustrating a local source line array architecture of an STT-MRAM device configured for midpoint sensing, according to an aspect of the present disclosure. The operation and the components of the STT-MRAM device of FIG. 7 may be substantially similar to the operation and the components of the STT-MRAM device 600 of FIG. 6. Specifically, the circuit components shown in FIG. 7 that are identical or substantially similar to those illustrated in FIG. 6 may have the same or substantially similar operations as those of the corresponding components illustrated in FIG. 6, and thus the descriptions of these components may or may not be repeated in the following sections. However, certain differences may be described below, including the addition of a second reference bit line 713 (also referred to herein as a bridge element 713, as a true reference bit line 713, or simply as a reference bit line 713). The STT-MRAM device 700 may include an STT-MRAM bit cell array 720 (e.g., the bit lines 730 of the array 720), which may be coupled to column selection circuitry 708, which may in turn be coupled to a sense amplifier 712. Specifically, a plurality of bit lines 730 in the array 720, including the selected bit line 706 and return bit lines 707, may be connected to an input 704 of the sense amplifier 712 through the column selection circuitry 708. Further, while a first reference bit line 705 (also referred to herein as a dummy reference bit line 705 or as a floating reference bit line 705) in the array 720 may not be connected to an input 702 of the sense amplifier 712, a second reference bit line 713 may be connected to the input 702 of the sense amplifier 712 through the column selection circuitry 708 and a trim circuit midpoint generator 710. Therefore, for the purpose of midpoint reference generation, the second reference bit line 713 may be used instead of the first reference bit line 705.

The bit cell array 720 may include a plurality of columns, with each column including a plurality of MTJs 718 and select transistors 717 coupled thereto. Notably, the plurality of columns includes a reference column 711 configured for midpoint reference generation, as well as one or more regular columns configured for data storage using MTJs. The bit cell array 720 may also include a plurality of rows, with each row including a local source line 714 and a plurality of MTJs 718 connected to the local source line 714 via the respective select transistors 717. Each MTJ 718 may be coupled between the bit line 730 and a first electrode 717A (e.g., a source) of the select transistor (e.g., select transistor 717) while a second electrode 717B (e.g., a drain) of each select transistor 717 may be coupled to the local source line 714 that runs parallel across the row in which the MTJ 718 is positioned. Each row may contain a single word line 715 that connects to the control electrodes (e.g., gates) of all select transistors 717 positioned across that row.

The local source lines 714 may be extended into the reference column 711 and may be electrically connected to the respective second electrodes of the select transistors 717. For example, for every predetermined number of columns (e.g., 32 columns), a reference column 711, including the first reference bit line 705, MTJs 718 connected to the first reference bit line 705, and the second reference bit line 713 may be added as an additional column (e.g., a 33^{rd} column). An advantage of placing a reference bit cell on a same local source line as the other MTJ devices positioned on the same row is that the return path has the same MTJ devices, thus improving uniformity. Additionally, the return path MTJ resistance is present in both reference and regular bit lines during sensing.

The reference column 711 may include the second reference bit line 713 connected to a transistor associated with each of the rows within the array 720. As discussed above, in FIG. 6, the element 613 may be connected across the MTJs 618 and the corresponding select transistors 617 within the reference column 611. In FIG. 7, the second reference bit line 713 may be connected across the select transistors 717 (at the source of each select transistor 717) within the reference column 711, but may not be connected to the MTJs 718 within the reference column 711, leaving the MTJs 718 disconnected (e.g., floating) on one end by, for example, removing the via below the bottom of the MTJs 718. This configuration may provide an additional reference bit line (e.g., the second reference bit line 713) functioning similar to that of the reference bit line 605 in FIG. 6. In one embodiment, the first reference bit line 705 may be floating as illustrated in FIGS. 6 and 7; in another embodiment, the first reference bit line 705 may be electrically connected to a fixed voltage (e.g., ground or VDD). Certain advantages of the second reference bit line 713 being incorporated into the generation of the reference generation circuitry may include setting a resistance that may not be dependent on the characteristics and/or states of the MTJs 718. In this regard, the second reference bit line 713 may no longer be electrically parallel with the first reference bit line 705 via the MTJs 718. In addition, wherein the MTJ is formed above metal layer M2, using M2 metal layer or any lower level metal layer below the MTJ to form the second reference bit line 713 may provide MTJ pattern uniformity in the array, thereby simplifying manufacturing process thereof and enabling set resistance. For example, where the MTJ is disposed above M4 metal layer, in one embodiment, a second reference bit line may be fabricated in metal layer(s) M1, M2, M3 and M4.

Thus, where the MTJ is formed immediately above metal layer M2, a lower level metal layer (e.g., M2, M1, M0) may be used to form a second reference bit line 713 whereby such second reference bit line is formed below the associated bitcell(s). In this embodiment, a single line of metal layer or equivalent may be used to create the set resistance in the reference column 711. That is, the lower level metal layer used to form the second reference bit line 713 may be sized (e.g., the metal width and/or multiple metal lines in parallel may be sized) to closely match the resistance of the reference bit line 605 in FIG. 6 or the bit line 630.

The trim circuit midpoint generator 710 may include a temperature-dependent tracking circuit 725 (also referred to herein as a tracking circuit 725) and a circuit element 703. The tracking circuit 725 may be configured to adjust a temperature coefficient of the current on the second reference bit line 713. For example, the column selection circuitry 708 connected to the second reference bit line 713 may in turn be connected to the circuit element 703 (e.g., programmable resistor or resistance) within the trim circuit midpoint generator 710. In addition, the tracking circuit 725 may be configured to control a magnitude of the current Iref or a temperature coefficient using proportional to absolute temperature (PTAT) or complementary to absolute temperature (CTAT) current or voltage generation techniques. In one embodiment, the tracking circuit 725 may control the magnitude of the current Iref by using an external current or voltage that includes a PTAT or CTAT current or voltage generation mechanism. The tracking circuit 725 may include any type of current mirror and/or tracking circuit. For example, a transfer gate, and/or a PMOS switch or NMOS switch may be used. In some embodiments, rather than using an NMOS mirror in the tracking circuit 725, a PMOS mirror may be used to inject current. In some embodiments, the tracking circuit 725 may not include a current mirror but may include any other tracking circuit to perform the tracking function by providing a temperature dependent voltage. In other embodiments, the tracking circuit 725 may include a current mirror, as shown in FIG. 7.

The circuit element 703 may include one or more poly resistors (e.g., a chain of poly resistors (e.g., in one embodiment, one or more non-trimmable resistors or one or more trimmable resistors; in another embodiment, one or more trimmable resistors and one or more trimmable resistors (as illustrated in FIG. 7)). The trim of the resistors may be implemented in multiple ways, including, for example, by shorting to a transfer gate or via fuses/anti-fuses). The circuit element 703 may include any type of resistor suitable for the application or design requirements. For example, in some embodiments, a combination of one or more poly resistors and one or more n-well resistors may be used to adjust a temperature coefficient without adjusting a current. In other embodiments, trimmable resistors with different temperature coefficients may be configured/programed to achieve a desired temperature coefficient. Further, any two resistive materials with different temperature coefficients may be used together in order to achieve a desired temperature coefficient. In some embodiments, the trimmable resistors may be any programmable voltage and/or current device configured to mimic the desired resistance of the STT-MRAM. The circuit element 703 may include a fixed resistance, a trimmable resistance, or a combination of a fixed resistance and one or more trimmable resistances depending on the configuration and the application of use. Poly resistors may have different characteristics than an MRAM MTJ. For instance, to obtain a temperature coefficient that is similar to that of an MTJ, a current trim circuitry may be used that has a temperature dependent magnitude of the current that it takes out from the reference bit line 705. By controlling the current being taken out (e.g., current 709), the amount of resistance the sense amplifier 712 sees on the second reference bit line 713 may be controlled. While poly resistors may have characteristics that are different from those of an MTJ, by controlling the reference current, Iref (e.g., 701), the characteristics may become more comparable (or even almost identical) to those of an MTJ. The reference current, Iref, may have a temperature coefficient to match the resistance of the parallel high and low-state MTJs across temperature. A poly resistor resistance value may be determined by using any one of multiple methods, such as an average of low state MTJ and high state MTJ resistances or parallel resistance configuration of low and high state MTJ resistances with any offset resistance. A poly resistor may be implemented with a series of small resistors with a small resolution (e.g., 250 or 500 Ohm) covering a wide range (e.g., 2k Ohm) around a center value (e.g., 4k Ohm).

Notably, in one embodiment, the temperature dependent magnitude referenced herein may change based on an operating temperature of the array or an associated portion thereof (e.g., the portion of the array which may be associated with the particular reference bit line at issue). In one embodiment, the change of the temperature coefficient over temperature may be linear. In another embodiment, the change of the temperature coefficient may be non-linear wherein the slope may change (e.g., increase or decrease) over temperature.

With continued reference to FIG.7, in another exemplary embodiment, the trim circuit midpoint generator 710 may use any type of resistance - whether passive or active. For example, the resistance (whether programmable or non-programmable (i.e., fixed, for example )) may be implemented using one or more active devices or circuit, for example, one or more transfer gates, and/or one or more PMOS switches and/or one or more NMOS switches (for example, a circuit including a plurality of PMOS switches and a plurality of NMOS switches). Moreover, in some embodiments, rather than using an NMOS mirror in the tracking circuit 725, a PMOS mirror may be used to inject current which, in effect, may adjust or control the resistance that may be present at or applied to the input of the sense amplifier 712 (which may also include the resistance of the reference bit line 713). Indeed, as noted above, in some embodiments, the tracking circuit 725 may not include a current mirror but may include a passive or active circuit to perform a temperature tracking function, for example, a temperature dependent voltage. In yet other embodiments, the tracking circuit 725 may include a current mirror, for example, as shown in FIG. 7, in addition to passive or another active circuit to implement the temperature tracking operation. The tracking circuit 725 included in the trim circuit midpoint generator 710 may be configured to control a magnitude of the current Iref or a temperature coefficient.

While FIG. 7 describes an exemplary embodiment in a local source line array architecture, the aforementioned tracking circuit 725, trim circuit midpoint generator 710, reference column 711, and second reference bitline 713 may be implemented in a standard source line array architecture as in FIG. 17 or any other array architecture. In a standard source line array architecture, reference column 711 may include a source line running in the same direction as the bitline illustrated in FIG. 17. The reference source line may be shared among multiple columns.

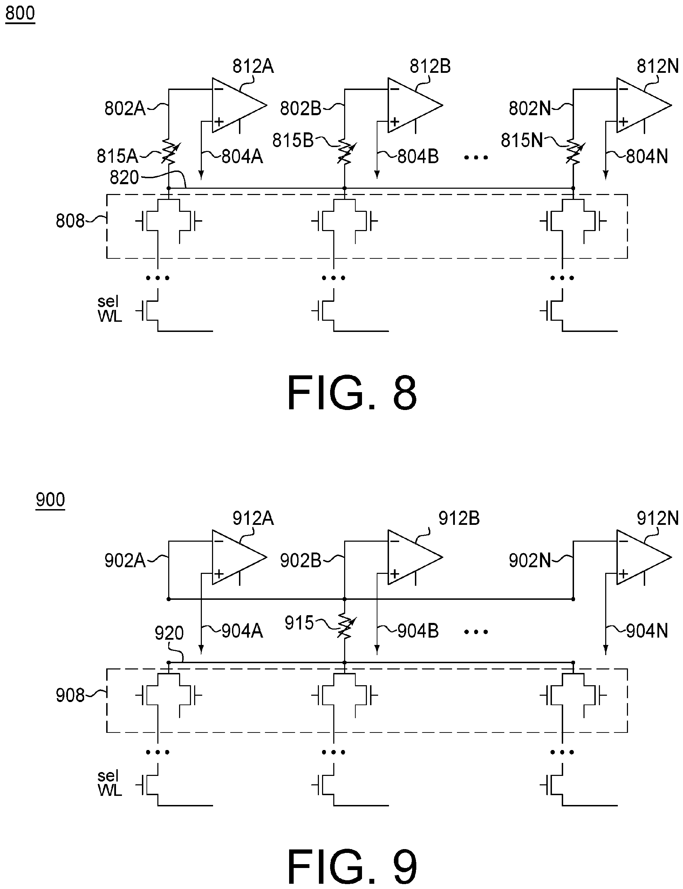

FIG. 8 depicts an exemplary schematic diagram illustrating a sense amplifier configuration of an STT-MRAM device configured for midpoint sensing, according to an aspect of the present disclosure. The sense amplifier described with respect to FIG. 8 may be identical or substantially similar to the sense amplifier(s) described in FIGS. 6 and 7. The sense amplifier configuration illustrated in FIG. 8 may be used or combined with other embodiments described herein. Sense amplifier configuration 800 may include a plurality of sense amplifiers (e.g., 812A, 812B, ..., 812N) each connected to a corresponding bit array (e.g., the bit array 620 or 720), including a reference bit line (e.g., the reference bit line 605 or the second reference bit line 713), a selected bit line (e.g., the selected bit line 606 or 706), and return bit lines (e.g., the return bit lines 607 or 707) through a column selection circuitry (e.g., the column selection circuitry 608 or 708), as described above with respect to FIGS. 6 and 7. A first sense amplifier 812A may include an input 802A and an input 804A. The input 804A may be connected to the bit array through a column selection circuitry 808. In one embodiment, the connection to the bit array may be to a local or common source line of the bit array. The input 802A may be connected to the reference bit line (e.g., the reference bit line 605 or the second reference bit line 713) through a first resistor 815A and the column selection circuitry 808. The first resistor 815A may be identical or similar to the circuit element 603 or 703 described above. The first resistor 815A may include a fixed resistance, a trimmable resistance, or a combination of a fixed resistance and one or more trimmable resistances depending on the configuration and the application of use. The first resistor 815A may be any type of resistor or any programmable device configured to mimic and control resistance using either voltage or current.

A second sense amplifier 812B may be identical or substantially similar to the first sense amplifier 812A. The first resistor 815A connected to the input 802A and a second resistor 815B connected to an input 802B may be connected in parallel via a connection 820. Connecting the first resistor 815A and the second resistor 815B in parallel may provide an average resistance between the connected resistors (e.g., the resistors 815A and 815B). The same logic applies as additional sense amplifiers (e.g., the sense amplifier 812N) and the corresponding resistors (e.g., the Nth resistor 815N) and reference bit lines are added to the configuration. Using an average resistance of the connected resistors may provide substantially similar current and voltage across the reference bit lines of the respective sense amplifiers. This may provide consistency among the sense amplifiers as well as the reference bit lines connected in the STT-MRAM device. In addition, the resistors connected in parallel may generate a more consistent average resistance to effectively reduce the mismatched current and/or voltage supplied to each word line of the STT-MRAM device (e.g., reduce the mismatch by a square root of N, which is the number of sense amplifiers in the configuration). The connection 820 effectively ties the reference bit lines corresponding to the plurality of sense amplifier and averages any mis-match current provided to each word line.

The sense amplifier configuration 800 may utilize a plurality of sense amplifiers (e.g., 812A through 812N) to gain the benefit of averaging the resistance for each of the connected sense amplifiers connected. In some embodiments, the sense amplifier configuration 800 may include up to approximately 32 sense amplifiers connected in parallel. In some embodiments, the number of connected sense amplifiers may depend on the size and configuration of the STT-MRAM and additional requirements (e.g., timing requirements). The number of sense amplifiers connected may provide a more accurate average resistance, for example, the more sense amplifiers connected in series may provide a more accurate and precise average resistance.

FIG. 9 depicts another exemplary schematic diagram illustrating a sense amplifier configuration of an STT-MRAM device configured for midpoint sensing, according to an aspect of the present disclosure. The sense amplifier described with respect to FIG. 9 may be identical or substantially similar to the sense amplifier(s) described in FIGS. 6 and 7. The sense amplifier configuration illustrated in FIG. 9 may be used or combined with other embodiments described herein. Sense amplifier configuration 900 may include a plurality of sense amplifiers (e.g., 912A, 912B, ..., 912N) each connected to a corresponding bit array (e.g., the bit array 620 or 720), including a reference bit line (e.g., the reference bit line 605 or the second reference bit line 713), a selected bit line (e.g., the selected bit line 606 or 706), and return bit lines (e.g., the return bit lines 607 or 707) through a column selection circuitry (e.g., the column selection circuitry 608 or 708) as described above with respect to FIGS. 6 and 7. A first sense amplifier 912A may include an input 902A and an input 904A. The input 904A may be connected to the bit array through a column selection circuitry 908. In one embodiment, the connection to the bit array may be to a local or common source line of the bit array. The input 902A may be connected to the reference bit line (e.g., the reference bit line 605 or the second reference bit line 713) through a resistor 915 and the column selection circuitry 908. The resistor 915 may be identical or similar to the circuit element 603 or 703 as described above. The resistor 915 may include a fixed resistance, a trimmable resistance, or a combination of a fixed resistance and one or more trimmable resistances depending on the configuration and the application of use. The resistor 915 may be any type of resistor or any programmable device configured to mimic and control resistance using either voltage or current.

A second sense amplifier 912B (and any additional sense amplifier, e.g., the sense amplifier 912N) may be identical or substantially similar to the first sense amplifier 912A. The second sense amplifier 912B (and any additional sense amplifier, e.g., the sense amplifier 912N) may be connected in parallel to the first sense amplifier 912A through the resistor 915. The resistor 915 may connect each of the sense amplifiers (e.g., 912A, 912B, ..., 912N) connected via connection 920 in parallel to the corresponding bit array through the column selection circuitry 908. To maintain the same reference current, Iref, the effective resistance may be divided by N (e.g., Rtrim/N), N being the number of sense amplifiers in the configuration. In some embodiments, Rtrim/N may be achieved by placing a number of resistors in parallel. Connecting the sense amplifiers in parallel may enable using a single resistance for each of the connected sense amplifiers. Using a single resistance may provide substantially similar current and voltage that drives through the reference bit line of each connected bit array. This may provide a consistency among the connected sense amplifiers as well as the reference bit lines in the STT-MRAM device. In addition, using a single resistor or resistance may lead to a smaller footprint or area of the STT-MRAM device on the circuit. The use of a single resistor or resistance may address the need to replicate a similar resistance among the sense amplifiers and/or the reference bit lines.

The sense amplifier configuration 900 may utilize a plurality of sense amplifiers (e.g., 912A through 912N) to gain the benefit of a single resistor or resistance for each of the connected sense amplifiers. In some embodiments, the sense amplifier configuration 900 may include up to approximately 32 sense amplifiers connected in parallel. In some embodiments, the number of connected sense amplifiers may depend on the size and configuration of the STT-MRAM and additional requirements.

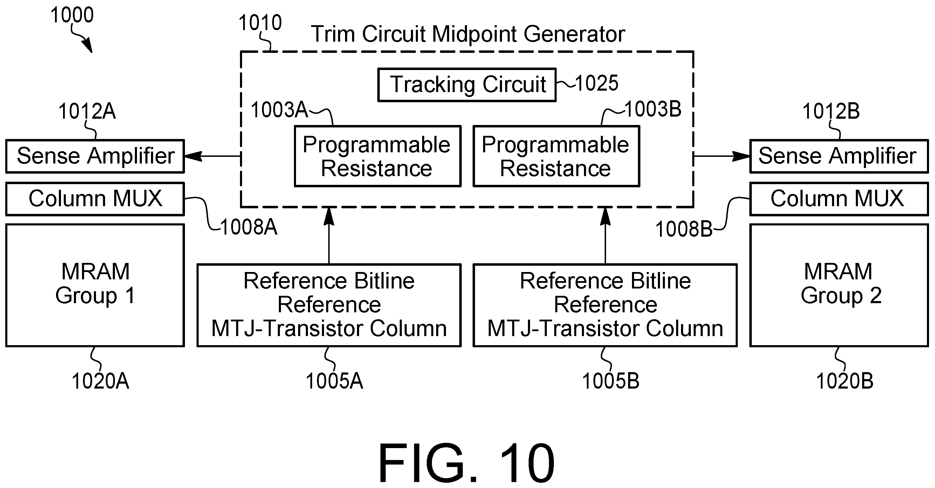

FIGS. 10-15 depict exemplary schematic block diagrams illustrating shared components (e.g., tracking circuit, programmable resistance, reference bit line, or a combination thereof) between a plurality (in the illustrated embodiment, two) of subarrays of memory cells of the memory cell array of an STT-MRAM device configured for midpoint sensing, according to one or more embodiments of the present disclosure. Notably, a memory cell array of the device described herein may include a plurality of groups of memory cells (e.g., 24, 36, 48, 96, ... 1024, 2048, ....). As an example, FIG. 10 illustrates the MRAM group 1 is associated with a reference bit line, sense amplifier, and programmable resistance, which are all dedicated to MRAM group 1. Similarly, the MRAM group 2 is associated with a reference bit line, sense amplifier, and programmable resistance, which are all dedicated to MRAM group 2. The tracking circuit midpoint generator is shared by each reference bit line and programmable resistance associated with the MRAM group 1 and MRAM group 2 (two subarrays of memory cells of the memory cell array of an STT-MRAM device). In one embodiment, the two subarrays are located adjacent each other in the memory cell array. Additional configurations of shared components will be described in further detail below. One having ordinary skill in the art may add and/or remove additional components while keeping with the scope of the embodiments described herein.

FIG. 10 depicts an exemplary schematic block diagram illustrating a shared tracking circuit configuration of an STT-MRAM device configured for midpoint sensing, according to an aspect of the present disclosure. As described above with respect to FIGS. 6 and 7, a trim circuit midpoint generator (e.g., the trim circuit midpoint generator 610 or 710) may include a circuit element (e.g., the circuit element 603 or 703) and a tracking circuit (e.g., the tracking circuit 625 or 725). Similarly, the STT-MRAM device 1000 of FIG. 10 may include some or all of the components of the STT-MRAM device described above with respect to FIGS. 6 and 7. The STT-MRAM device 1000 illustrated in FIG. 10 may be used or combined with other embodiments described herein. The STT-MRAM device 1000 may be configured to share a single tracking circuit 1025 between two or more sense amplifier groups. In the present disclosure, a sense amplifier group (also referred to herein as a magnetoresistive memory array group) may include one or more of the following components: a sense amplifier, a trim circuit midpoint generator including a tracking circuit and a programmable resistance, a column selection circuitry (e.g., each column MUX shown in FIGS. 10-15), and a bit cell array (e.g., each MRAM group shown in FIGS. 10-15) including one or more reference bit lines (e.g., each reference bit line shown in FIGS. 10-15). The STT-MRAM device 1000 may include a trim circuit midpoint generator 1010, a first sense amplifier 1012A, a second sense amplifier 1012B, a first column MUX 1008A, a second column MUX 1008B, an MRAM group 1 1020A, an MRAM group 2 1020B, a first reference bit line 1005A, and a second reference bit line 1005B. The trim circuit midpoint generator 1010 may include a tracking circuit 1025, a first programmable resistance 1003A, and a second programmable resistance 1003B. Here, the memory array of the device 1000 may include a plurality of groups of memory cells or subarrays of memory cells (in the illustrated embodiment, 1020A and 1020B). The MRAM group 1 1020A may be associated with reference bit line of 1005A and sense amplifier 1012A. The MRAM group 2 1020B may be associated with reference bit line of 1005B and sense amplifier 1012B.

As shown in FIG. 10, the tracking circuit 1025 may be shared among the two sense amplifier groups. The tracking circuit 1025 may be configured to perform operations identical or substantially similar to those described in FIGS. 6 and 7 for tracking circuits 625 and 725. The tracking circuit 1025 may be configured to control a magnitude of a current (e.g., Iref), and control the temperature coefficient and the trim coefficient of a programmable resistance (e.g., the circuit element 603 or 703). The tracking circuit 1025 may include a trimmable temperature coefficient feature (e.g., Iref 601 or 701) in which the magnitude of Iref may be trimmed by one or more of a fuse, antifuse programming, or register load to obtain different magnitudes that are dependent on a temperature. In some embodiments, the tracking circuit 1025 may include a current mirror including a trim circuit configured to adjust a temperature dependent magnitude. In some embodiments, the tracking circuit 1025 may include other tracking circuits in lieu of a current mirror. The tracking circuit 1025 may be electrically connected to the first programmable resistance 1003A and the second programmable resistance 1003B within the trim circuit midpoint generator 1010. The tracking circuit 1025 may be configured to control the temperature coefficient and the trim coefficient of each of the first programmable resistance 1003A and the second programmable resistance 1003B. The advantages of using a single tracking circuit 1025 for a plurality of sense amplifier groups may include reducing the circuit complexity and area required within a chip. Additionally, using a single tracking circuit may allow for a more efficient and consistent adjustment between each of the sense amplifiers within the STT-RAM device. Maintaining a consistent adjustment of the temperature coefficient and the trim coefficient may allow for a more accurate and consistent current flow between the sense amplifiers and their corresponding bit cell arrays.

As similarly described above in FIGS. 6 and 7, the first reference bit line 1005A and the MRAM group 1 1020A may be connected to the first sense amplifier 1012A through the first column MUX 1008A and the first programmable resistance 1003A. Similarly, the second reference bit line 1005B and the MRAM group 2 1020B may be connected to the second sense amplifier 1012B through the second column MUX 1008B and the second programmable resistance 1003B. The tracking circuit 1025 may be configured to control and adjust the temperature coefficient and trim coefficient of each the first programmable resistance 1003A and the second programmable resistance 1003B.

The STT-MRAM device 1000 of FIG. 10 shows two sense amplifier groups sharing a single tracking circuit. However, in some embodiments, more than two sense amplifier groups may be connected to share a single tracking circuit as described herein. For example, the tracking circuit 1025 may be configured to control three or more programmable resistance devices each connected to a corresponding reference bit line, in a substantially similar manner as described herein.

In one embodiment, the sense amplifier may be configured to select one reference bit line from among a plurality of reference bit lines at a time. For instance, where the first sense amplifier 1012A is associated with eight reference bit lines, the first sense amplifier 1012A may select a single reference bit line from the eight reference bit lines to use for midpoint sensing during a read operation. The selection of which reference bit line to use may be controlled by the column selection circuitry (e.g., the first column MUX 1008A). This configuration may provide flexibility in selecting different reference bit lines based on various factors such as proximity to the memory cells being read, manufacturing variations, or operational conditions.

In another embodiment, the sense amplifier may be configured to select and use more than one reference bit line simultaneously. For example, where the first sense amplifier 1012A is associated with eight reference bit lines, the first sense amplifier 1012A may select two or more of the eight reference bit lines concurrently for use in midpoint sensing. In some cases, the sense amplifier may select and use all of the associated reference bit lines simultaneously. Using multiple reference bit lines simultaneously may provide averaging benefits similar to those described with respect to FIGS. 8 and 9, but within a single sense amplifier group rather than across multiple sense amplifier groups. This approach may improve the accuracy and reliability of the midpoint reference generation by reducing the impact of variations among individual reference bit lines.

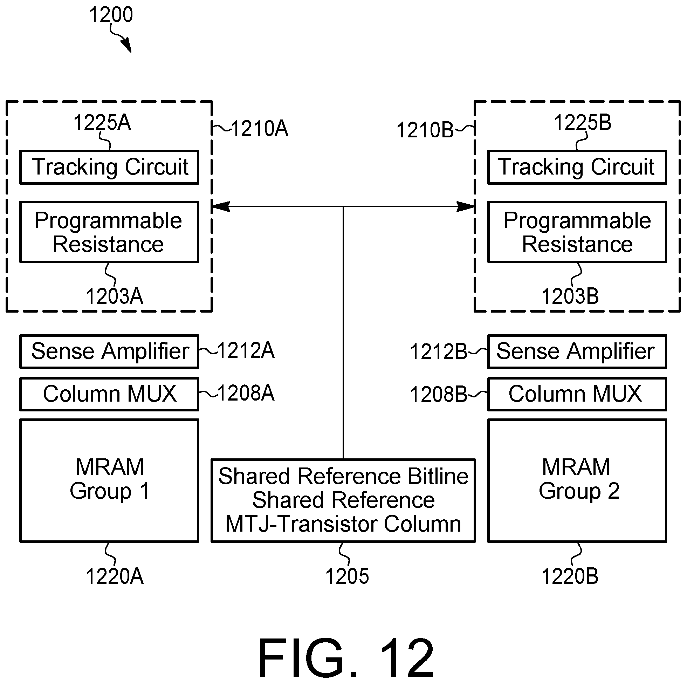

In yet another embodiment, each sense amplifier group may include its own dedicated tracking circuit in addition to its own programmable resistance. For example, rather than sharing the single tracking circuit 1025 between the MRAM group 1 1020A and the MRAM group 2 1020B, each MRAM group (e.g., MRAM group 1 1020A and the MRAM group 2 1020B) may have its own tracking circuit. In this instance, the first sense amplifier 1012A and the MRAM group 1 1020A may be associated with a first tracking circuit and the first programmable resistance 1003A, while the second sense amplifier 1012B and the MRAM group 2 1020B may be associated with a second tracking circuit, different from the first tracking circuit, and the second programmable resistance 1003B. This approach, where each sense amplifier has its own tracking circuit and programmable resistance, may improve yield and robustness of the sense amplifiers by programming the individual tracking circuit and programmable resistance uniquely for each sense amplifier or for each group of sense amplifiers.. This embodiment may be similar to that illustrated in FIG. 12, except that each MRAM group may have its own dedicated reference bit line rather than sharing a common reference bit line.

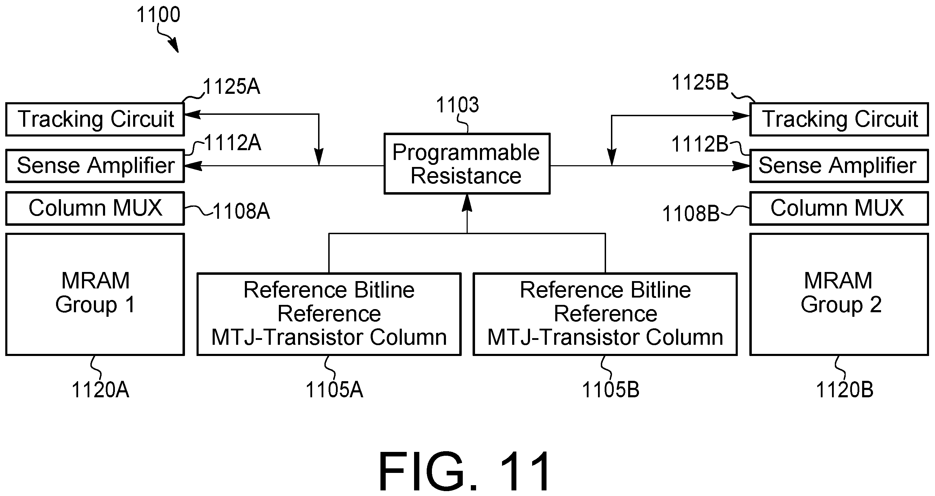

FIG. 11 depicts an exemplary schematic block diagram illustrating a shared programmable resistance configuration of an STT-MRAM device configured for midpoint sensing, according to an aspect of the present disclosure. The STT-MRAM device 1100 of FIG. 11 may include some or all of the components of the STT-MRAM device described above with respect to FIGS. 6 and 7. The STT-MRAM device 1100 illustrated in FIG. 11 may be used or combined with other embodiments described herein. The STT-MRAM device 1100 may include two or more sense amplifier groups. The STT-MRAM device 1100 may include a first tracking circuit 1125A, a first sense amplifier 1112A, a first column MUX 1108A, an MRAM group 1 1120A, and a first reference bit line 1105A. The STT-MRAM device 1100 may further include a second tracking circuit 1125B, a second sense amplifier 1112B, a second column MUX 1108B, an MRAM group 2 1120B, and a second reference bit line 1105B. Notably, the STT-MRAM device 1100 may share a programmable resistance 1103 among the two sense amplifier groups. Here, the memory array of the device 1100 may include a plurality of groups of memory cells or subarrays of memory cells (in the illustrated embodiment, 1120A and 1120B). In this embodiment, the MRAM group 1 1120A is associated with reference bit line of 1105A, sense amplifier 1112A, and tracking circuit 1125A. The reference bit line of 1105A and tracking circuit 1125A are employed to generate the reference for the midpoint sensing of memory cells of MRAM group 1 1120A. The MRAM group 2 1120B may be associated with reference bit line of 1105B, sense amplifier 1112B, and tracking circuit 1125B. The reference bit line of 1105B and tracking circuit 1125B are employed to generate the reference for the midpoint sensing of memory cells of MRAM group 2 1120B.

The programmable resistance 1103 may be configured to provide a resistance, in connection with generating a reference for the midpoint sensing, to each of the sense amplifier groups. The programmable resistance 1103 may include any type of resistor or programmable device to mimic or control a resistance using voltage and/or current. The programmable resistance 1103 may include a fixed resistance, a trimmable resistance, or a combination of a fixed resistance and one or more trimmable resistances depending on the configuration and the application of use, as described above with respect to circuit elements 603 and 703 of FIGS. 6 and 7.

The STT-MRAM device 1100 of FIG. 11 shows two sense amplifier groups sharing a single programmable resistance. However, in some embodiments, more than two sense amplifier groups may be connected to share a programmable resistance as described herein. For example, the programmable resistance 1103 may be configured to provide resistance for three or more sense amplifier groups in a substantially similar manner as described herein.

FIG. 12 depicts an exemplary schematic block diagram illustrating a shared reference bit line configuration of an STT-MRAM configured for midpoint sensing, according to an aspect of the present disclosure. The STT-MRAM device 1200 of FIG. 12 may include some or all of the components of the STT-MRAM device described above with respect to FIGS. 6 and 7. The STT-MRAM device 1200 illustrated in FIG. 12 may be used or combined with other embodiments described herein. The STT-MRAM device 1200 may include two or more sense amplifier groups. The STT-MRAM device 1200 may include a first trim circuit midpoint generator 1210A including a first tracking circuit 1225A and a first programmable resistance 1203A, a first sense amplifier 1212A, a first column MUX 1208A, and an MRAM group 1 1220A. The STT-MRAM device 1200 may further include a second trim circuit midpoint generator 1210B including a second tracking circuit 1225B and a second programmable resistance 1203B, a second sense amplifier 1212B, a second column MUX 1208B, and an MRAM group 2 1220B. The STT-MRAM device 1200 may share a reference bit line 1205 among the two sense amplifier groups. Here, the memory array of the device 1200 may include a plurality of groups of memory cells or subarrays of memory cells (in the illustrated embodiment, 1220A and 1220B). The MRAM group 1 1220A may be associated with the reference bit line of 1205, the first sense amplifier 1212A, and the first trim circuit midpoint generator 1210A. The MRAM group 2 1220B may be associated with the reference bit line of 1205, the second sense amplifier 1212B, and the second trim circuit midpoint generator 1210B.

The reference bit line 1205 may be identical or substantially similar to the reference bit line 605 or 705 described above with respect to FIGS. 6 and 7. The reference bit line 1205 may be a shared reference bit line for the multiple memory arrays of device 1200 (in the illustrated embodiment, MRAM group 1 1220A and MRAM group 2 1220B) and dedicated to generating a reference for midpoint sensing in connection with reading data states of memory cells of MRAM group 1 1220A and MRAM group 2 1220B. Some advantages of using a shared reference bit line may include reducing the area or size of the STT-MRAM device 1200 by utilizing a single reference bit line shared by multiple sense amplifier groups. In this configuration, by placing the reference bit line in close proximity to the MRAM groups (e.g., the bit cell arrays), the accuracy, efficiency, and reliability of the STT-MRAM device and its midpoint sensing capability may be improved.

The STT-MRAM device 1200 of FIG. 12 shows two sense amplifier groups sharing a single reference bit line. However, in some embodiments, more than two sense amplifier groups may be connected to share a reference bit line as described herein. For example, the reference bit line 1205 may be configured to provide a reference bit line for three or more sense amplifier groups in a substantially similar manner as described herein.

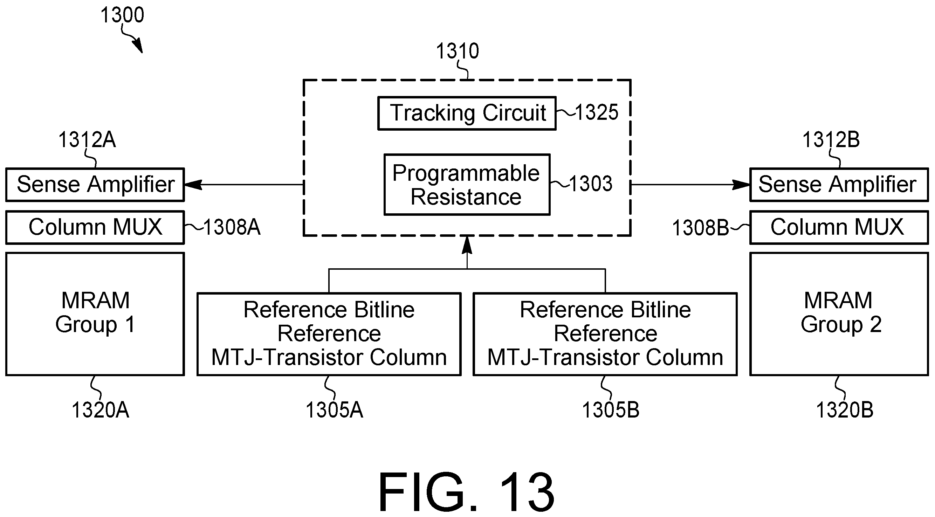

FIG. 13 depicts an exemplary schematic block diagram illustrating a shared trim circuit midpoint generator configuration of an STT-MRAM configured for midpoint sensing, according to an aspect of the present disclosure. As described above with respect to FIGS. 6 and 7, a trim circuit midpoint generator (e.g., the trim circuit midpoint generator 610 or 710) may include a circuit element (e.g., the circuit element 603 or 703) and a tracking circuit (e.g., the tracking circuit 625 or 725). Similarly, the STT-MRAM device 1300 of FIG. 13 may include some or all of the components of the STT-MRAM device described above with respect to FIGS. 6 and 7. The STT-MRAM device 1300 illustrated in FIG. 13 may be used or combined with other embodiments described herein. The STT-MRAM device 1300 may be configured to share a single trim circuit midpoint generator 1310 including a tracking circuit 1325 and a programmable resistance 1303 among two or more sense amplifier groups. The STT-MRAM device 1300 may include the trim circuit midpoint generator 1310, a first sense amplifier 1312A, a second sense amplifier 1312B, a first column MUX 1308A, a second column MUX 1308B, an MRAM group 1 1320A, an MRAM group 2 1320B, a first reference bit line 1305A, and a second reference bit line 1305B. The trim circuit midpoint generator 1310 may include the tracking circuit 1325 and the programmable resistance 1303. Here, the memory array of the device 1300 may include a plurality of groups of memory cells or subarrays of memory cells (in the illustrated embodiment, 1320A and 1320B). The MRAM group 1 1320A may be associated with reference bit line of 1305A and sense amplifier 1312A. The MRAM group 2 1320B may be associated with reference bit line of 1305B and sense amplifier 1312B. The trim circuit midpoint generator 1310 and the reference bit line of 1305A, generates a reference for the midpoint sensing during read operations in connection with memory cells of MRAM group 1 1320A. In addition, the trim circuit midpoint generator 1310 and the reference bit line of 1305B, generates a reference for the midpoint sensing during read operations in connection with memory cells of MRAM group 2 1320B.

The tracking circuit 1325 and the programmable resistance 1303 may thus be shared among multiple sense amplifier groups. The tracking circuit 1325 may be configured to perform operations substantially similar to those described in FIGS. 6 and 7 for tracking circuits 625 and 725. The tracking circuit 1325 may be configured to control a magnitude of a current (e.g., Iref), and control the temperature coefficient and the trim coefficient of the programmable resistance 1303 (e.g., the circuit element 603 or 703). The tracking circuit 1325 may include a trimmable temperature coefficient feature (e.g., Iref 601 or 701) in which the magnitude of Iref may be trimmed by one or more of a fuse, antifuse programming, or register load to obtain different magnitudes that are dependent on a temperature. In some embodiments, the tracking circuit 1325 may include a current mirror including a trim circuit configured to adjust a temperature dependent magnitude. In some embodiments, the tracking circuit 1325 may include other tracking circuits in lieu of a current mirror. The tracking circuit 1325 may be electrically connected to the programmable resistance 1303 within the trim circuit midpoint generator 1310. The tracking circuit 1325 may be configured to control the temperature coefficient and the trim coefficient of the programmable resistance 1303. The advantages of using a single tracking circuit 1325 for a plurality of sense amplifier groups may include reducing the circuit complexity and area required within a chip. Additionally, using a single tracking circuit may allow for a more efficient and consistent adjustment between each of the sense amplifiers within the STT-RAM device. Maintaining a consistent adjustment of the temperature coefficients and the trim coefficients may allow for a more accurate and consistent current flow between the sense amplifiers and their corresponding bit cell arrays.

The programmable resistance 1303 may be configured to provide a resistance to each of the connected sense amplifier groups. The programmable resistance 1303 may include any type of resistor or programmable device to mimic or control a resistance using voltage and/or current. The programmable resistance 1303 may include a fixed resistance, a trimmable resistance, or a combination of a fixed resistance and one or more trimmable resistances depending on the configuration and the application of use, as described above with respect to circuit elements 603 and 703 of FIGS. 6 and 7. The technical benefits of using a single programmable resistance to be shared by multiple sense amplifier groups may include the same benefits as those described in reference to FIG. 9.

In some embodiments, the tracking circuit 1325 and the programmable resistance 1303 may be separate components as described above. In other embodiments, the tracking circuit 1325 and the programmable resistance 1303 may be combined into a single component. For example, the tracking circuit 1325 may include the programmable resistance 1303 causing the reference bit line(s) (e.g., 1305A and/or 1305B) to be directly connected to the tracking circuit 1325. This may provide the benefit of a closed-circuit programmable resistance. In this way, the tracking circuit 1325 may control the temperature coefficients and the trim coefficients of the programmable resistance 1303 in a more area efficient and seamless manner to multiple sense amplifiers (e.g., 1312A and 1312B).

The STT-MRAM device 1300 of FIG. 13 shows two sense amplifier groups sharing a single trim circuit midpoint generator 1310. However, in some embodiments, more than two sense amplifier groups may be connected to share a trim circuit midpoint generator as described herein. For example, the trim circuit midpoint generator 1310 may be configured to provide a tracking circuit and a programmable resistance for three or more sense amplifier groups in a substantially similar manner as described herein.

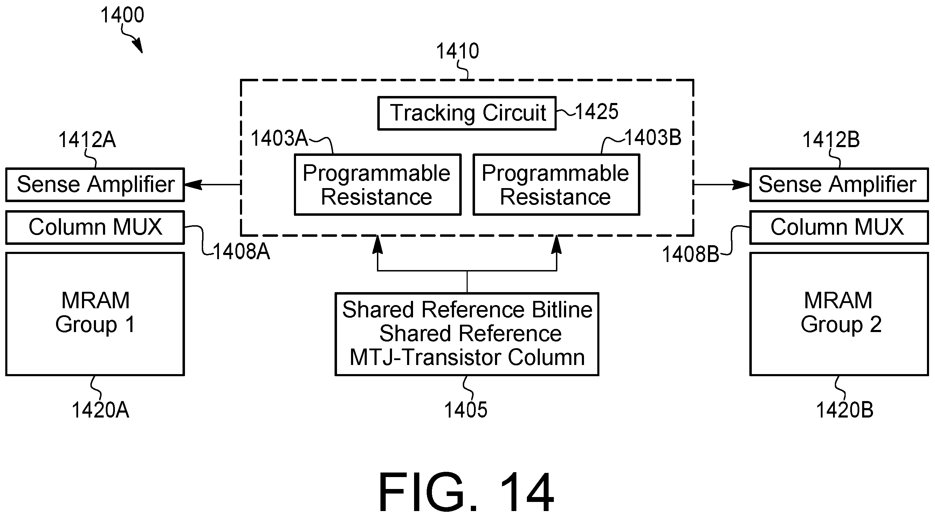

FIG. 14 depicts an exemplary schematic block diagram illustrating a shared tracking circuit and reference bit line configuration of an STT-MRAM device configured for midpoint sensing, according to an aspect of the present disclosure. As described above with respect to FIGS. 6 and 7, a trim circuit midpoint generator (e.g., the trim circuit midpoint generator 610 or 710) may include a circuit element (e.g., the circuit element 603 or 703) and a tracking circuit (e.g., the tracking circuit 625 or 725). Similarly, the STT-MRAM device 1400 of FIG. 14 may include some or all of the components of the STT-MRAM device described above with respect to FIGS. 6 and 7. The STT-MRAM device 1400 illustrated in FIG. 14 may be used or combined with other embodiments described herein. Notably, as will be described further below, the STT-MRAM device 1400 may include the shared components of FIGS. 10 and 12 (e.g., the tracking circuit 1025 and the reference bit line 1205). The STT-MRAM device 1400 may be configured to share tracking circuit 1425 and reference bit line 1405 among two or more sense amplifier groups. The STT-MRAM device 1400 may include a trim circuit midpoint generator 1410, a first sense amplifier 1412A, a second sense amplifier 1412B, a first column MUX 1408A, a second column MUX 1408B, an MRAM group 1 1420A, an MRAM group 2 1420B, and a reference bit line 1405. The trim circuit midpoint generator 1310 may include a tracking circuit 1425, a first programmable resistance 1403A, and a second programmable resistance 1403B. Here, the memory array of the device 1400 may include a plurality of groups of memory cells or subarrays of memory cells (in the illustrated embodiment, 1420A and 1420B). The MRAM group 1 1420A may be associated with reference bit line of 1405 and sense amplifier 1412A. The MRAM group 2 1420B may be associated with reference bit line of 1405 and sense amplifier 1412B.

The tracking circuit 1425 and the reference bit line 1405 may thus be shared among multiple sense amplifier groups. The tracking circuit 1425 may be configured to perform operations identical or substantially similar to those described in FIGS. 6 and 7 for tracking circuits 625 and 725. The tracking circuit 1425 may be configured to control a magnitude of a current (e.g., Iref), and control the temperature coefficient and the trim coefficient of the programmable resistance(s) 1403A and/or 1403B. The tracking circuit 1425 may include a trimmable temperature coefficient feature (e.g., Iref 601 or 701) in which the magnitude of Iref may be trimmed by one or more of a fuse, antifuse programming, or register load to obtain different magnitudes that are dependent on a temperature. In some embodiments, the tracking circuit 1425 may include a current mirror including a trim circuit configured to adjust a temperature dependent magnitude. In some embodiments, the tracking circuit 1425 may include other tracking circuits in lieu of a current mirror. The tracking circuit 1425 may be electrically connected to the programmable resistance(s) (e.g., 1403A and 1403B) within the trim circuit midpoint generator 1410. The tracking circuit 1425 may be configured to control the temperature coefficient and the trim coefficient of the first programmable resistance 1403A and the second programmable resistance 1403B. The advantages of using a single tracking circuit 1425 for a plurality of sense amplifier groups may include reducing the circuit complexity and area required within a chip. Additionally, using a single tracking circuit may allow for a more efficient and consistent adjustment between each of the sense amplifiers within the STT-RAM device. Maintaining a consistent adjustment of the temperature coefficient and the trim coefficient may allow for a more accurate and consistent current flow between the sense amplifiers and their corresponding bit cell arrays.

The reference bit line 1405 may be identical or substantially similar to the reference bit line 605 or 705 described above with respect to FIGS. 6 and 7. The reference bit line 1405 may be a dedicated, share reference bit line for the multiple memory arrays of device 1400. Some advantages of using a shared reference bit line may include reducing the area or size of the STT-MRAM device 1400 by utilizing a single reference bit line shared by multiple sense amplifier groups. In this configuration, by placing the reference bit line in close proximity to the MRAM groups (e.g., the bit cell arrays), the accuracy, efficiency, and reliability of the STT-MRAM device and its midpoint sensing capability may be improved.

The STT-MRAM device 1400 of FIG. 14 shows two sense amplifier groups sharing a tracking circuit and a reference bit line. However, in some embodiments, more than two sense amplifier groups may be connected to share a tracking circuit and a reference bit line as described herein. For example, the tracking circuit 1425 and the reference bit line 1405 may be shared among three or more sense amplifier groups in a substantially similar manner as described herein.

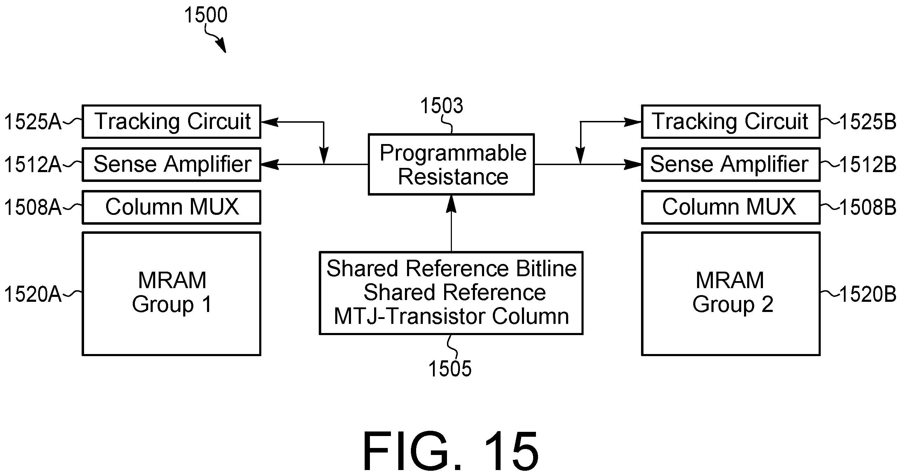

FIG. 15 depicts an exemplary schematic block diagram illustrating a shared programmable resistance and reference bit line configuration of an STT-MRAM device configured for midpoint sensing, according to an aspect of the present disclosure. The STT-MRAM device 1500 of FIG. 15 may include some or all of the components of the STT-MRAM device described above with respect to FIGS. 6 and 7. The STT-MRAM device 1500 illustrated in FIG. 15 may be used or combined with other embodiments described herein. The STT-MRAM device 1500 may include two or more sense amplifier groups. Notably, as will be described further below, the STT-MRAM device 1500 may include the shared components of FIGS. 11 and 12 (e.g., the programmable resistance 1103 and the reference bit line 1205). The STT-MRAM device 1500 may be configured to share a programmable resistance 1503 and a reference bit line 1505 between two or more sense amplifier groups. The STT-MRAM device 1500 may include a first tracking circuit 1525A, a second tracking circuit 1525B, a first sense amplifier 1512A, a second sense amplifier 1512B, a first column MUX 1508A, a second column MUX 1508B, an MRAM group 1 1520A, an MRAM group 2 1520B, and a reference bit line 1505. Here, the memory array of the device 1500 may include a plurality of groups of memory cells or subarrays of memory cells (in the illustrated embodiment, 1520A and 1520B). The MRAM group 1 1520A is associated with reference bit line of 1505, sense amplifier 1512A, and tracking circuit 1525A. The MRAM group 2 1520B is associated with reference bit line of 1505, sense amplifier 1512B, and tracking circuit 1525B. The reference bit line of 1505, programmable resistance 1503 and tracking circuit 1525A generates a reference for the midpoint sensing during read operations in connection with memory cells of MRAM group 1 1520A. In addition, reference bit line of 1505, programmable resistance 1503 and tracking circuit 1525B generates a reference for the midpoint sensing during read operations in connection with memory cells of MRAM group 2 1520B.

The programmable resistance 1503 may be configured to provide a resistance to each of the connected sense amplifier groups. The programmable resistance 1503 may include any type of resistor or programmable device to mimic or control a resistance using voltage and/or current. The programmable resistance 1503 may include a fixed resistance, a trimmable resistance, or a combination of a fixed resistance and one or more trimmable resistances depending on the configuration and the application of use, as described above with respect to circuit elements 603 and 703 of FIGS. 6 and 7. The technical benefits of using a single programmable resistance to be shared by multiple sense amplifier groups may include the same benefits as those described in reference to FIG. 9.

The reference bit line 1505 may be identical or substantially similar to the reference bit line 605 or 705 described above with respect to FIGS. 6 and 7. The reference bit line 1505 may be a dedicated, shared reference bit line for the multiple memory arrays of device 1500. Some advantages of using a shared reference bit line may include reducing the area or size of the STT-MRAM device 1500 by utilizing a single reference bit line shared by multiple sense amplifier groups. In this configuration, by placing the reference bit line in close proximity to the MRAM groups (e.g., the bit cell arrays), the accuracy, efficiency, and reliability of the STT-MRAM device and its midpoint sensing capability may be improved.

In some embodiments, the programmable resistance 1503 and the reference bit line 1505 may be separate components as described above. In other embodiments, the programmable resistance 1503 and the reference bit line 1505 may be combined into a single component. For example, the programmable resistance 1503 may be incorporated into the reference bit line 1505 causing the reference bit line 1505 to include the temperature and the trim coefficients of the programmable resistance. This may then allow the tracking circuit(s) to seam-lessly control the coefficients of the combined component prior to providing an input to the sense amplifier. This may improve the efficiency of the STT-MRAM device.

In some embodiments, a tracking circuit, a programmable resistance, and a reference bit line may be combined into a single component. For example, the tracking circuit, programmable resistance, and reference bit line may be implemented into a single block where the reference bit line is outside the MTJ bit cell array. In such cases, the reference bit line may be implemented using replica metal lines or resistors and a plurality of bit cell select transistors that are not part of the main MTJ bit cell array.

The STT-MRAM device 1500 of FIG. 15 shows two sense amplifier groups sharing a programmable resistance and a reference bit line. However, in some embodiments, more than two sense amplifier groups may be connected to share a programmable resistance and a reference bit line as described herein. For example, the programmable resistance 1503 and the reference bit line 1505 may be shared among three or more sense amplifier groups in a substantially similar manner as described herein.

With reference to the embodiments illustrated in FIGS. 10-15, in some embodiments, each MRAM group and its associated sense amplifier may be configured with multiple reference bit lines rather than a single reference bit line. In such configurations, the sense amplifier may be configured to select one reference bit line from among the plurality of reference bit lines at a time for use during midpoint sensing operations. Alternatively, the sense amplifier may be configured to select and use more than one reference bit line simultaneously, which may provide averaging benefits within a single sense amplifier group. Additionally, in some embodiments, each sense amplifier group may include its own dedicated tracking circuit in addition to its own programmable resistance, rather than sharing a single tracking circuit among multiple sense amplifier groups. This modular approach, where each sense amplifier has its own tracking circuit and programmable resistance, may improve yield and robustness of the sense amplifiers by programming the individual tracking circuit and programmable resistance uniquely for each sense amplifier or for each group of sense amplifiers.

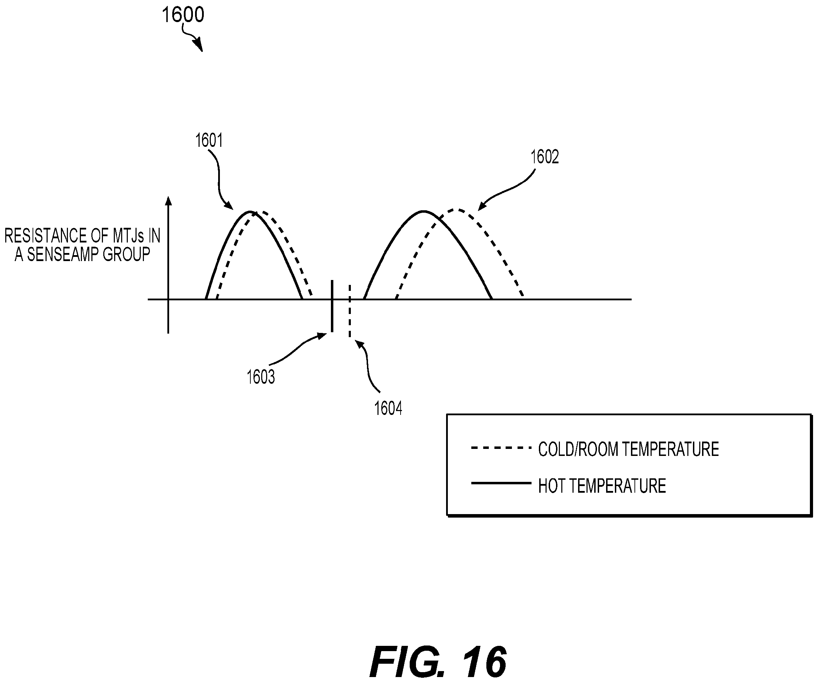

FIG. 16 depicts an exemplary graph illustrating a shift in resistance of a low-state MTJ and a high-state MTJ based on temperature. Graph 1600 may include two curves 1601 illustrate resistance distributions of a low-state MTJ and the two curves 1602 illustrate resistance distributions of a high-state MTJ. The dashed lines illustrate resistance distributions of MTJs at a cold temperature or room temperature. The solid lines illustrate resistance distributions of MTJs at a hot temperature. Line 1603 (e.g., midpoint 1603) illustrates a midpoint between the solid lines representative of the resistance distributions at the hot temperature. Line 1604 (e.g., midpoint 1604) illustrates a midpoint between the dotted lines representative of the resistance distributions at the cold temperature or room temperature.

In the low-state distribution represented by the curves 1601, the solid curve for the hot temperature does not drift as far away from the dotted curve for the cold temperature as compared to the high-state distribution represented by the curves 1602. In some cases of the low-state distribution represented by the curves 1601, the solid curve for the hot temperature may not drift any significant amount from the dotted curve for the cold temperature. When the solid curve for the hot temperature moves farther from the dotted curve for the cold temperature as shown in the high-state distribution represented by the curves 1602, the midpoint 1603 is shifted farther away from the midpoint 1604. This may affect the operation of the MRAM device by slowing sensing and/or increasing bit failures. According to an exemplary embodiment, the temperature control coefficient may be controlled to protect against the shifting of the high-state distribution. For example, by taking current off of the reference bit line 605 or by injecting current into the reference bit line 605, as described above in the description of FIG. 6, the temperature effect may be adjusted. The midpoint reference position is adjusted with temperature to maximize the read signal for reading low-state and high-state distributions by the sense amplifier. Thus the reference current, Iref, may be used to control the temperature coefficient.

FIG. 17 depicts an exemplary diagram illustrating a memory architecture of an STT-MRAM device, in accordance with an exemplary embodiment. The array architecture may be a standard source line array where each column of MRAM bitcells may include a bitline and a source line. A memory architecture 1700 of an STT-MRAM device may include word line drivers, column circuit controls (e.g., gap circuits), read/write circuits comprising sense amplifiers and write drivers, and column multiplexer switches. Word line drivers may generate appropriate word line voltages for word lines, in order to select/activate one or more word lines to access MTJ(s) along the selected word line(s). Gap circuit may generate and send address signals (e.g., column decode line signals, read/write enable signals, etc.) to column multiplexer switches and read/write circuits (e.g., sense amplifiers and write drivers) to, for example, allow for local decoding that determines which bit lines and source lines are to be driven for a particular operation (e.g., read, write, etc.). The local decoding may control the selective driving of the bit lines and source lines by the read/write circuits and may also control the sense amplifiers' selective coupling to, or sensing of, the memory cells for determination of data bits stored therein. More particularly, the read/write enable signals may each provide an indication as to whether memory cells included in the array are to be accessed for a particular operation (e.g., read, write, etc.). The column decode line signals may control the column multiplexer switches to select desired bit line and source line columns. The column multiplexer switches may comprise bit line column multiplexer switches and source line column multiplexer switches. The bit line column multiplexer switches may be configured to provide a unidirectional read current and may be implemented with either a NMOS or a PMOS-type transistor. The bit line column multiplexer switches may be further configured to provide a bidirectional write current and may be implemented with a transfer gate, PMOS-type transistor, or auto-booted NMOS transistor. The source line column multiplexer switches may be configured to provide a bidirectional current and may be implemented with a transfer gate or auto-booted NMOS transistor. In another embodiment, the source line column multiplexer switches may be connected to bit lines in the bit cell array where a local source line bit cell array is used as depicted in FIG. 5. In yet another embodiment, a plurality of columns may share only one source line that is connected to the source line column multiplexer switches.

As alluded to above, read/write circuit may comprise sense amplifiers and write drivers, and may be coupled to bit lines and source lines, to provide appropriate voltages to certain bit lines and source lines used to perform an operation. The selection of the bit lines and the source lines that are driven is based on the address information received from the gap circuit, where the address information may be decoded and used to determine the memory cells to be accessed. If, for example, a target memory cell is included in a page to be accessed, the read/write circuit may use the decoded address to selectively drive those bit lines and source lines suitable for accessing the corresponding MTJ.

Reading the state of an MTJ and determining the bit represented by that state (e.g., a read operation, or a single bit read operation) may be performed by the read/write circuit, which may include a sense amplifier configured to sense a low voltage signal representing the stored bit and amplify it to a recognizable logic level. Further, reading the states of two MTJs and determining the bit represented by those states (e.g., a differential bit read operation) may also be performed by the read/write circuit including the sense amplifier, the sense amplifier being configured to sense the low power signals representing the states of the MTJs and determine the single bit represented by the differing states. Because these two MTJs store complementary states, the comparison may be simple in that one MTJ will have a relatively higher resistance than the other MTJ producing an increased sense signal. As such, the magnitude of the resistance variation in a distribution of MTJs is less important in the case of a differential bit read operation, relative to that of a single bit read operation. To perform the read operations discussed above, a sense amplifier may be connected to each column of MTJs for reading the data values stored therein.

According to an exemplary embodiment, a sense amplifier may include a preamplifier and a latch, and the preamplifier may regulate voltage on a bit line during a read operation.

While exemplary embodiments have been presented above, it should be appreciated that many variations exist. Furthermore, while the description uses STT-MRAM devices that include memory cells in a specific example arrangements, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

In one embodiment, a magnetoresistive device may include a magnetoresistive memory array comprising a plurality of magnetoresistive devices arranged in a plurality of rows and a plurality of columns, wherein: the plurality of columns includes a reference column and a regular column, the regular column includes a regular bit line and a first subset of magnetoresistive devices of the plurality of magnetoresistive devices, the first subset of magnetoresistive devices coupled to the regular bit line and a plurality of select devices within the regular column; and the reference column includes a reference bit line, a dummy reference bit line, and a second subset of magnetoresistive devices of the plurality of magnetoresistive devices, the second subset of magnetoresistive devices coupled to the dummy reference bit line, and the reference bit line coupled to a plurality of select devices within the reference column; a column selection circuitry configured to select the regular bit line or the reference bit line; a sense amplifier coupled to the column selection circuitry, the sense amplifier including a first input associated with the reference bit line and a second input connected to the regular bit line through the column selection circuitry; and a trim circuit midpoint generator including a tracking circuit and a programmable resistance, the tracking circuit connected to the first input of the sense amplifier and the programmable resistance, and the programmable resistance connected to the tracking circuit and the reference bit line through the column selection circuitry.

Various embodiments of the magnetoresistive device may include wherein each of the second subset of magnetoresistive devices includes a first connector and a second connector, the first connector coupled to the dummy reference bit line and the second connector is floating; wherein the reference column is configured to set a resistance within the reference bit line that does not depend on a resistance of each of the second subset of magnetoresistive devices; wherein the tracking circuit is configured to adjust a temperature coefficient associated with a reference current in the reference bit line; wherein the tracking circuit is configured to adjust a trim coefficient associated with the programmable resistance; wherein the tracking circuit includes at least one of a current mirror or another circuit configured to adjust a temperature coefficient by providing a temperature dependent voltage; wherein the tracking circuit is configured to adjust a reference current associated with the programmable resistance and the reference column based on a temperature of the magnetoresistive device; wherein the tracking circuit is a current mirror configured to adjust a temperature dependent current; and wherein the programmable resistance includes one or more of a fixed resistance or a trimmable resistance.

In another embodiment, a magnetoresistive device may include a magnetoresistive device comprising: a plurality of magnetoresistive memory array groups, each magnetoresistive memory array group of the plurality of magnetoresistive memory array groups comprising: a plurality of magnetoresistive devices arranged in a plurality of rows and a plurality of columns, wherein: the plurality of columns comprise a reference column and a regular column, the regular column comprises a regular bit line and a first subset of magnetoresistive devices of the plurality of magnetoresistive devices, the first subset of magnetoresistive devices coupled to the regular bit line and a plurality of select devices within the regular column; and the reference column comprises a reference bit line, a dummy reference bit line, and a second subset of magnetoresistive devices of the plurality of magnetoresistive devices, the second subset of magnetoresistive devices coupled to the dummy reference bit line, and the reference bit line coupled to a plurality of select devices within the reference column; a column selection circuitry configured to select the regular bit line or the reference bit line; a sense amplifier coupled to the column selection circuitry, the sense amplifier including a first input associated with the reference bit line and a second input connected to the regular bit line through the column selection circuitry; and a trim circuit midpoint generator including a tracking circuitry, the tracking circuit connected to the first input of the sense amplifier and to the reference bit line through the column selection circuitry.

Various embodiments of the magnetoresistive device may include wherein the trim circuit midpoint generator further includes a programmable resistance, the programmable resistance in the trim circuit midpoint generator of each magnetoresistive memory array group connected to one another via a connection; wherein the trim circuit midpoint generator further includes a programmable resistance between the column selection circuitry and the first input of the sense amplifier, the programmable resistance in the trim circuit midpoint generator of each magnetoresistive memory array group connected to one another in parallel; and the magnetoresistive device further comprising a programmable resistance, wherein the programmable resistance is connected to each sense amplifier via a separate connection and shared across the plurality of magnetoresistive memory array groups.

In yet another embodiment, a magnetoresistive device may a magnetoresistive device comprising: a plurality of magnetoresistive memory array groups, each magnetoresistive memory array group of the plurality of magnetoresistive memory array groups comprising: a plurality of magnetoresistive memory devices arranged in a plurality of rows and a plurality of columns, wherein: the plurality of columns comprise a reference column and a regular column, the regular column comprises a regular bit line and a first subset of magnetoresistive devices of the plurality of magnetoresistive devices, the first subset of magnetoresistive devices coupled to the regular bit line and a plurality of select devices within the regular column; and the reference column comprises a reference bit line, the reference bit line coupled to a plurality of select devices within the reference column; a column selection circuitry configured to select the regular bit line or the reference bit line; a sense amplifier coupled to the column selection circuitry, the sense amplifier including a first input associated with the reference bit line and a second input connected to the regular bit line through the column selection circuitry; and a tracking circuit connected to the first input of the sense amplifier; and a programmable resistance connected to the tracking circuit and the column selection circuitry.

Various embodiments of the magnetoresistive device may include wherein the tracking circuit is shared among the plurality of magnetoresistive memory array groups, such that there is a single tracking circuit used by the plurality of magnetoresistive memory groups; wherein the programmable resistance is shared among the plurality of magnetoresistive memory array groups, such that there is a single programmable resistance used by the plurality of magnetoresistive memory groups; wherein the reference column including the reference bit line is shared among the plurality of magnetoresistive memory array groups, such that there is a single reference column used by the plurality of magnetoresistive memory groups; wherein the tracking circuit is shared among the plurality of magnetoresistive memory array groups, such that there is a single tracking circuit used by the plurality of magnetoresistive memory array groups, and wherein the programmable resistance is shared among the plurality of magnetoresistive memory array groups, such that there is a single programmable resistance used by the plurality of magnetoresistive memory groups; wherein the tracking circuit is shared among the plurality of magnetoresistive memory array groups, such that there is a single tracking circuit used by the plurality of magnetoresistive memory array groups, and wherein the reference column including the reference bit line is shared among the plurality of magnetoresistive memory array groups, such that there is a single reference column used by the plurality of magnetoresistive memory groups; and wherein the programmable resistance is shared among the plurality of magnetoresistive memory array groups, such that there is a single programmable resistance used by the plurality of magnetoresistive memory groups, and wherein the reference column including the reference bit line is shared among the plurality of magnetoresistive memory array groups, such that there is a single reference column used by the plurality of magnetoresistive memory groups.

The foregoing description of the inventions has been described for purposes of clarity and understanding. It is not intended to limit the inventions to the precise form disclosed. Various modifications may be possible within the scope and equivalence of the application.

Moreover, there are many inventions, and aspects thereof, described and illustrated herein. While certain embodiments, features, attributes and advantages of the inventions have been described and illustrated, it should be understood that many others, as well as different and/or similar embodiments, features, attributes and advantages of the present inventions, are apparent from the description and illustrations. The exemplary claims presented below include one or more features of the present inventions. Importantly, there are many inventions and many features thereof. Other claims, including those claims filed in non-provisional application(s) claiming priority hereto: (i) may or may not include one, some or all of the limitations set forth in the exemplary claims presented below and/or (ii) may or may not include one, some or all of the combinations of the limitations set forth in exemplary claims presented below. To be sure, the exemplary claims presented below are not representative of the entire scope and/or breadth of the present inventions.

## Claims

1. A magnetoresistive device comprising:
a magnetoresistive memory array comprising a plurality of magnetoresistive devices arranged in a plurality of rows and a plurality of columns, wherein:
the plurality of columns includes a reference column and a regular column,
the regular column includes a regular bit line and a first subset of magnetoresistive devices of the plurality of magnetoresistive devices, the first subset of magnetoresistive devices coupled to the regular bit line and a plurality of select devices within the regular column; and
the reference column includes a reference bit line, a dummy reference bit line, and a second subset of magnetoresistive devices of the plurality of magnetoresistive devices, the second subset of magnetoresistive devices coupled to the dummy reference bit line, and the reference bit line coupled to a plurality of select devices within the reference column;
a column selection circuitry configured to select the regular bit line or the reference bit line;
a sense amplifier coupled to the column selection circuitry, the sense amplifier including a first input associated with the reference bit line and a second input connected to the regular bit line through the column selection circuitry; and
a trim circuit midpoint generator including a tracking circuit and a programmable resistance, the tracking circuit connected to the first input of the sense amplifier and the programmable resistance, and the programmable resistance connected to the tracking circuit and the reference bit line through the column selection circuitry.

2. The magnetoresistive device of claim 1, wherein each of the second subset of magnetoresistive devices includes a first connector and a second connector, the first connector coupled to the dummy reference bit line and the second connector is floating.

3. The magnetoresistive device of claim 1, wherein the reference column is configured to set a resistance within the reference bit line that does not depend on a resistance of each of the second subset of magnetoresistive devices.

4. The magnetoresistive device of claim 1, wherein the tracking circuit is configured to adjust a temperature coefficient associated with a reference current in the reference bit line 1, and/or wherein the tracking circuit is configured to adjust a trim coefficient associated with the programmable resistance, and/or wherein the tracking circuit includes at least one of a current mirror or another circuit configured to adjust a temperature coefficient by providing a temperature dependent voltage 1, and/or wherein the tracking circuit is configured to adjust a reference current associated with the programmable resistance and the reference column based on a temperature of the magnetoresistive device.

5. The magnetoresistive device of any of claims 1 to 4, wherein the tracking circuit is a current mirror configured to adjust a temperature dependent current.

6. The magnetoresistive device of any of claims 1 to 5, wherein the programmable resistance includes one or more of a fixed resistance or a trimmable resistance.

7. A magnetoresistive device comprising:
a plurality of magnetoresistive memory array groups, each magnetoresistive memory array group of the plurality of magnetoresistive memory array groups comprising:
a plurality of magnetoresistive devices arranged in a plurality of rows and a plurality of columns, wherein:
the plurality of columns comprise a reference column and a regular column,
the regular column comprises a regular bit line and a first subset of magnetoresistive devices of the plurality of magnetoresistive devices, the first subset of magnetoresistive devices coupled to the regular bit line and a plurality of select devices within the regular column; and
the reference column comprises a reference bit line, a dummy reference bit line, and a second subset of magnetoresistive devices of the plurality of magnetoresistive devices, the second subset of magnetoresistive devices coupled to the dummy reference bit line, and the reference bit line coupled to a plurality of select devices within the reference column;
a column selection circuitry configured to select the regular bit line or the reference bit line;
a sense amplifier coupled to the column selection circuitry, the sense amplifier including a first input associated with the reference bit line and a second input connected to the regular bit line through the column selection circuitry; and
a trim circuit midpoint generator including a tracking circuitry, the tracking circuit connected to the first input of the sense amplifier and to the reference bit line through the column selection circuitry.

8. The magnetoresistive device of claim 7, wherein the trim circuit midpoint generator further includes a programmable resistance, the programmable resistance in the trim circuit midpoint generator of each magnetoresistive memory array group connected to one another via a connection.

9. The magnetoresistive device of any of claims 7 or 8, wherein the trim circuit midpoint generator further includes a programmable resistance between the column selection circuitry and the first input of the sense amplifier, the programmable resistance in the trim circuit midpoint generator of each magnetoresistive memory array group connected to one another in parallel.

10. The magnetoresistive device of any of claims 7 to 9, further comprising a programmable resistance, wherein the programmable resistance is connected to each sense amplifier via a separate connection and shared across the plurality of magnetoresistive memory array groups.

11. A magnetoresistive device comprising:
a plurality of magnetoresistive memory array groups, each magnetoresistive memory array group of the plurality of magnetoresistive memory array groups comprising:
a plurality of magnetoresistive memory devices arranged in a plurality of rows and a plurality of columns, wherein:
the plurality of columns comprise a reference column and a regular column,
the regular column comprises a regular bit line and a first subset of magnetoresistive devices of the plurality of magnetoresistive devices, the first subset of magnetoresistive devices coupled to the regular bit line and a plurality of select devices within the regular column; and
the reference column comprises a reference bit line, the reference bit line coupled to a plurality of select devices within the reference column;
a column selection circuitry configured to select the regular bit line or the reference bit line;
a sense amplifier coupled to the column selection circuitry, the sense amplifier including a first input associated with the reference bit line and a second input connected to the regular bit line through the column selection circuitry; and
a tracking circuit connected to the first input of the sense amplifier; and
a programmable resistance connected to the tracking circuit and the column selection circuitry.

12. The magnetoresistive device of claim 11, wherein the tracking circuit is shared among the plurality of magnetoresistive memory array groups, such that there is a single tracking circuit used by the plurality of magnetoresistive memory groups.

13. The magnetoresistive device of claims 11 or 12, wherein the programmable resistance is shared among the plurality of magnetoresistive memory array groups, such that there is a single programmable resistance used by the plurality of magnetoresistive memory groups.

14. The magnetoresistive device of claims 11 to 13, wherein the reference column including the reference bit line is shared among the plurality of magnetoresistive memory array groups, such that there is a single reference column used by the plurality of magnetoresistive memory groups.

15. The magnetoresistive device of any of claims 11 to 13, wherein the tracking circuit is shared among the plurality of magnetoresistive memory array groups, such that there is a single tracking circuit used by the plurality of magnetoresistive memory array groups, and wherein the programmable resistance is shared among the plurality of magnetoresistive memory array groups, such that there is a single programmable resistance used by the plurality of magnetoresistive memory groups, and/orwherein the tracking circuit is shared among the plurality of magnetoresistive memory array groups, such that there is a single tracking circuit used by the plurality of magnetoresistive memory array groups, and wherein the reference column including the reference bit line is shared among the plurality of magnetoresistive memory array groups, such that there is a single reference column used by the plurality of magnetoresistive memory groups, and/or
wherein the programmable resistance is shared among the plurality of magnetoresistive memory array groups, such that there is a single programmable resistance used by the plurality of magnetoresistive memory groups, and wherein the reference column including the reference bit line is shared among the plurality of magnetoresistive memory array groups, such that there is a single reference column used by the plurality of magnetoresistive memory groups.
